# EUROPEAN PATENT APPLICATION

(11) **EP 4 485 544 A1**
(43) Date of publication of application: **01.01.2025**
(21) Application number: 24184206.1
(22) Date of filing: 25.06.2024
(51) Int. Cl.: H01L 29/45, H01L 29/786

(54) **SEMICONDUCTOR DEVICE**

(30) Priority: 27.06.2023 KR 20230082887
(71) Applicant: Samsung Electronics Co., Ltd., Suwon-si, Gyeonggi-do 16677 (KR)
(72) Inventor: YANG, Jeeeun, 16678 Suwon-si (KR); KIM, Sangwook, 16678 Suwon-si (KR); CHA, Youngkwan, 16678 Suwon-si (KR)
(74) Representative: Elkington and Fife LLP

(57) **Abstract**

A semiconductor device includes an oxide semiconductor layer, a first electrode and a second electrode, which are arranged apart from each other on the oxide semiconductor layer, a metal oxide layer arranged between the oxide semiconductor layer and at least one of the first electrode and the second electrode, and a metal nitride layer arranged between the metal oxide layer and the oxide semiconductor layer.

## Description

### FIELD OF THE INVENTION

Various example embodiments relate to a semiconductor device and/or a method of manufacturing the semiconductor device.

### BACKGROUND OF THE INVENTION

A transistor is a semiconductor device which performs the function of electric switching and is used in various integrated circuit (IC) devices including one or more of a memory, a driving IC, a logic device, etc. To increase the degree of integration of IC devices, the space occupied by transistors included in IC devices has been reduced, and research is being conducted to decrease the size of transistors while maintaining their performance.

Oxide semiconductor devices are transparent semiconductor devices characterized by a wide band gap of 3.0 eV or greater, and have been studied for years. Oxide semiconductor devices used in large-area display driving devices have characteristics such as electrical characteristics of a low off-current, a high on/off ratio, etc. The degree of integration may be increased by applying an oxide semiconductor device having the aforementioned characteristics to a memory or logic device or stacking the oxide semiconductor device on a Si-based device.

However, the short-channel effect due to scaling-down of oxide semiconductor devices may degrade the performance of oxide semiconductor devices. For example, as one or more of the width, length, thickness, etc. of a channel layer decrease, it is difficult to control Vth, and a reduced contact area between the channel layer and a source/drain may increase contact resistance. More specifically, when forming an oxide semiconductor layer on a source/drain formed of a metal material by using a precursor, the reaction between the precursor and the metal material may increase the contact resistance.

### SUMMARY OF THE INVENTION

Provided is a semiconductor device including a metal nitride layer.

Additional aspects will be set forth in part in the description which follows and, in part, will be apparent from the description, or may be learned by practice of the presented embodiments of the disclosure.

According to some example embodiments, a semiconductor device includes an oxide semiconductor layer, a first electrode and a second electrode that are apart from each other on the oxide semiconductor layer, a metal oxide layer between the oxide semiconductor layer and at least one of the first electrode and the second electrode, a metal nitride layer between the metal oxide layer and the oxide semiconductor layer, a gate electrode apart from the oxide semiconductor layer, and a gate insulating layer arranged between the oxide semiconductor layer and the gate electrode.

The metal nitride layer may include oxygen. At least one of a thickness of the metal oxide layer and a thickness of the metal nitride layer may be less than a thickness of the oxide semiconductor layer.

A thickness of the oxide semiconductor layer may be 10 nm or less.

A length of the oxide semiconductor layer may be less than 1 micron..

A thickness of the metal oxide layer may be 5 nm or less.

A thickness of the metal oxide layer may be about 0.5 nm to about 3.5 nm.

A thickness of the metal nitride layer may be 10 nm or less.

A thickness of the metal oxide layer may be 0.2 times to 2 times greater than a thickness of the metal nitride layer.

A thickness of the metal oxide layer may be less than or equal to 25 % of a thickness of the first electrode. The metal oxide layer may include a metal identical to a metal included in an electrode in contact with the metal oxide layer, the electrode being from the first electrode and the second electrode.

The metal oxide layer may include at least one of W, Co, Ni, Fe, Ti, Mo, Cr, Zr, Hf, Nb, Ta, Ag, Au, Al, Cu, Sn, V, Ru, Pt, Zn, and Mg.

The metal nitride layer may include at least one of Ga, W, Zn, V, and Ti.

A surface of at least one of the first electrode and the second electrode may be stepped by the metal oxide layer.

A width of the metal nitride layer may be greater than or equal to a width of the oxide semiconductor layer.

A difference between a width of the oxide semiconductor layer and a width of the metal nitride layer may be greater than or equal to a difference between the width of the oxide semiconductor layer and a width of the metal oxide layer.

The first electrode, the metal oxide layer, the metal nitride layer, the oxide semiconductor layer, and the second electrode may be arranged sequentially in a thickness direction of the first electrode.

The metal oxide layer may include a first metal oxide layer arranged between the first electrode and the oxide semiconductor layer and a second metal oxide layer arranged between the second electrode and the oxide semiconductor layer, and the metal nitride layer may be arranged between the first metal oxide layer and the oxide semiconductor layer.

The metal nitride layer may include a first metal nitride layer between the first metal oxide layer and the oxide semiconductor layer and a second metal nitride layer arranged between the second metal oxide layer and the oxide semiconductor layer.

A thickness of the first metal oxide layer may be different from a thickness of the second metal oxide layer.

The semiconductor device may be manufactured by an atomic layer deposition process.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a diagram illustrating a thin-film structure according to some example embodiments;
FIGS. 2A to 2C show transmission electron micrograph (TEM) images and dispersive x-ray spectroscopy (EDS) analysis results of a thin-film structure including a metal layer, a metal oxide layer, a metal nitride layer, and an oxide semiconductor layer;
FIG. 3 shows a TEM image and EDS analysis results of a thin-film structure including a metal layer, a metal oxide layer, and an oxide semiconductor layer, according to Comparative Example;
FIG. 4 is a graph showing IV characteristics of a transistor according to Examples and a Comparative Example;
FIG. 5 is a diagram illustrating a semiconductor device including a metal oxide layer and a metal nitride layer, according to some example embodiments;
FIG. 6 is a diagram illustrating a semiconductor device according to some example embodiments;
FIG. 7 is a diagram illustrating a semiconductor device according to some example embodiments;
FIG. 8 is a diagram illustrating a semiconductor device according to some example embodiments;
FIG. 9 is a diagram illustrating a semiconductor device according to some example embodiments;
FIG. 10 is a diagram illustrating a semiconductor device according to some example embodiments;
FIG. 11 is a diagram illustrating a semiconductor device according to some example embodiments;
FIG. 12 is a diagram illustrating a semiconductor device according to some example embodiments;
FIG. 13 is a diagram illustrating a semiconductor device according to some example embodiments;
FIG. 14 is a diagram illustrating a semiconductor device according to some example embodiments;
FIG. 15 is a diagram illustrating a semiconductor device according to some example embodiments;
FIGS. 16 to 24 are referential diagrams for explaining a method of manufacturing a semiconductor device according to some example embodiments;
FIG. 25 is a circuit diagram of a complementary metal-oxide semiconductor (CMOS) inverter according to some example embodiments;
FIG. 26 is a circuit diagram of a CMOS static random-access memory (SRAM) device according to some example embodiments;
FIG. 27 is a circuit diagram of a CMOS NAND circuit according to some example embodiments;
FIG. 28 is a block diagram illustrating an electronic system according to some example embodiments; and
FIG. 29 is a block diagram illustrating an electronic system according to some example embodiments.

### DETAILED DESCRIPTION

Reference will now be made in detail to some embodiments, examples of which are illustrated in the accompanying drawings, wherein like reference numerals refer to like elements throughout. In this regard, example embodiments may have different forms and should not be construed as being limited to the descriptions set forth herein. Accordingly, example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, a semiconductor device and/or a method of manufacturing the semiconductor device will be described in detail with reference to the accompanying drawings. In the drawings, like reference numerals denote like components, and sizes of components may be exaggerated for clarity and convenience of explanation.

An expression used in the singular encompasses the expression of the plural, unless it has a clearly different meaning in the context. When a portion "includes" a component, another component may be further included, rather than excluding the existence of the other component, unless otherwise described. Sizes or thicknesses of components in the drawings may be arbitrarily exaggerated for convenience of explanation. Further, when a certain material layer is described as being arranged on a substrate 101 or another layer, the material layer may be in contact with the substrate 101 or the other layer, or there may be a third layer between the material layer and the substrate 101 or the other layer. In embodiments, materials constituting each layer are provided merely as an example, and other materials may also be used.

Moreover, the terms "part," "module," etc. refer to a unit processing at least one function or operation, and may be implemented by a hardware, a software, or a combination thereof.

The particular implementations shown and described herein are illustrative examples of embodiments and are not intended to otherwise limit the scope of embodiments in any way. For the sake of brevity, conventional electronics, control systems, software development and other functional aspects of the systems may not be described in detail.

Furthermore, the connecting lines, or connectors shown in the various figures presented are intended to represent exemplary functional relationships and/or physical or logical couplings between the various elements. It should be noted that many alternative or additional functional relationships, physical connections or logical connections may be present in a practical device.

The use of the terms "a" and "an" and "the" and similar referents in the context of describing embodiments (especially in the context of the following claims) are to be construed to cover both the singular and the plural.

Also, the steps of all methods described herein can be performed in any suitable order unless otherwise indicated herein or otherwise clearly contradicted by context. The use of any and all exemplary languages (e.g., "such as") provided herein, are intended merely to better illuminate the technical ideas and does not pose a limitation on the scope of rights unless otherwise claimed.

The expression such as "at least" used to list elements is intended to limit a list of entire elements, rather than individual elements in the list. For example, expressions such as "at least one of A, B, and C" or "at least one selected from the group consisting of A, B, and C" may be interpreted as only A, only B, only C, or a combination of two or more of A, B, and C, e.g., ABC, AB, BC, and AC.

When the terms such as "about" or "substantially" are used in relation to numerical values, the relevant numerical value may be construed as including a manufacturing or operation deviation (e.g., ±10 %) of the stated numerical value. In addition, when the expressions such as "generally" and "substantially" are used in relation to a geometric shape, the geometric precision may not be required, and the intention is that the degree of tolerance regarding the shape is within the scope of embodiments of the disclosure. Moreover, regardless of whether a numerical value of a shape is limited by using "about" or "substantially", such numerical value or shape should be understood as including a manufacturing or operation deviation (e.g., ±10 %) of the stated numerical value.

While such terms as "first," "second," etc., may be used to describe various components, such components must not be limited to the above terms. The above terms are used only to distinguish one component from another.

The use of any and all examples, or exemplary language provided herein, is intended merely to better illuminate technical ideas and does not pose a limitation on the scope of embodiments unless otherwise claimed.

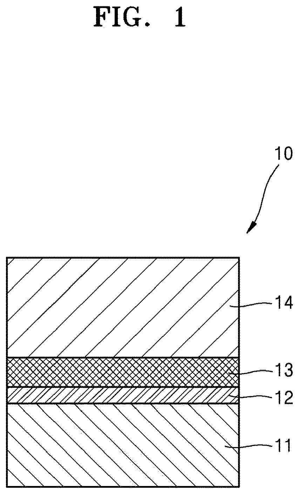

FIG. 1 is a diagram illustrating a thin-film structure 10 according to various example embodiments. The thin-film structure 10 of FIG. 1 may be a component of, e.g., may be included in, a semiconductor device. Referring to FIG. 1, the thin-film structure 10 may include a metal layer 11, a metal oxide layer 12 arranged on the metal layer 11, a metal nitride layer 13 arranged on the metal oxide layer 12, and an oxide semiconductor layer 14 arranged on the metal nitride layer 13.

The metal layer 11 may include at least one of tungsten (W), cobalt (Co), nickel (Ni), iron (Fe), titanium (Ti), molybdenum (Mo), chrome (Cr), zirconium (Zr), hafnium (Hf), niobium (Nb), tantalum (Ta), silver (Ag), gold (Au), aluminum (Al), copper (Cu), tin (Sn), vanadium (V), ruthenium (Ru), platinum (Pt), zinc (An), and magnesium (Mg). When the thin-film structure 10 is applied to a semiconductor device, the metal layer 11 may be an electrode of the semiconductor device, such as but not limited to a gate electrode, a source electrode, a drain electrode, or a body electrode.

A metal oxide layer 12 may be arranged on the metal layer 11. A metal included in the metal oxide layer 12 may be identical to a metal included in the metal layer 11. For example, the metal oxide layer 12 may include at least one of W, Co, Ni, Fe, Ti, Mo, Cr, Zr, Hf, Nb, Ta, Ag, Au, Al, Cu, Sn, V, Ru, Pt, An, and Mg.

A content of oxygen included in the metal oxide layer 12 may be changed or variable towards an oxide semiconductor layer 14 from the metal layer 11. For example, the content of oxygen included in the metal oxide layer 12 may decrease as a distance to oxide semiconductor layer 14 increases.

The metal oxide layer 12 may be formed by reacting a metal source on the metal layer 11 and/or by oxidizing a metal of the metal layer 11 by heat treatment, etc. in the process of forming the oxide semiconductor layer 14 or manufacturing a semiconductor device or an electronic apparatus including the thin-film structure 10. An interface between the metal layer 11 and the metal oxide layer 12 may be unclear or amorphous or not present. For example, the metal oxide layer 12 may be formed as a part of the metal layer 11. The metal oxide layer 12 may be formed discontinuously or continuously on the metal layer 11.

The metal nitride layer 13 may be arranged on the metal oxide layer 12. The electrical conductivity of the metal nitride layer 13 may be greater than the electrical conductivity of the oxide semiconductor layer 14 and may be less than the electrical conductivity of the metal layer 11. A metal included in the metal nitride layer 13 may be different from a metal included in the metal layer 11. The metal nitride layer 13 may include a metal which does not react to oxygen and remains stable or a metal which has a higher oxidation reactivity than a metal included in the metal layer 11 yet remains conductive even when the metal is oxidized.

The metal nitride layer 13 may include at least one of gallium (Ga), Mo, W, Zn, V, and Ti. For example, when the metal layer 11 includes W, the metal oxide may include GaN; example embodiments are not limited thereto.

The metal nitride layer 13 may further include oxygen. The content of oxygen included in the metal nitride layer 13 (at%) may be greater than or equal to the content of oxygen included in the metal oxide layer 12. The oxygen included in the metal nitride layer 13 may be included by directly injecting (e.g., implanting) an oxygen source when forming the metal nitride layer 13 and/or during a following process such as formation of the metal oxide layer 12, etc. For example, the oxygen may flow into the metal nitride layer 13 in the process of forming the oxide semiconductor layer 14 on the metal nitride layer 13 and/or manufacturing a semiconductor device or an electronic apparatus including the thin-film structure 10 of FIG. 1.

A cross-sectional area of the metal nitride layer 13 may be greater than or equal to a cross-section area of the metal oxide layer 12. A width of the metal nitride layer 13 may be greater than or equal to a width of the metal oxide layer 12. For example, a part of a lower surface of the metal nitride layer 13 may be in contact with the metal oxide layer 12, and another part of the lower surface of the metal nitride layer 13 may be in contact with the metal layer 11. In some example embodiments the metal nitride layer 13 may wrap around the metal oxide layer 12.

The oxide semiconductor layer 14 may be arranged on the metal nitride layer 13. The oxide semiconductor layer 14 according to some example embodiments may include at least one oxide of at least one material selected from at least one of Groups 12, 13, and 14 elements such as but not limited to Zn, indium (In), Ga, Sn, cadmium (Cd), germanium (Ge), or Hf, and a combination thereof. For example, the oxide semiconductor layer 14 may include a Zn oxide-based material such as a Zn oxide, an In-Zn oxide, an In-Ga-Zn oxide, etc. For example, the oxide semiconductor layer 14 may have a single layer structure or a multi-layer structure.

In the thin-film structure 10, interfaces among the metal layer 11, the metal oxide layer 12, the metal nitride layer 13, and the oxide semiconductor layer 14 may be unclear, amorphous, or not present.

The thin-film structure 10 may be applied to a semiconductor device having a channel length less than 1 um, about 500 nm or less, or about 50 nm or less. To this end, the metal layer 11, the metal oxide layer 12, the metal nitride layer 13, and the oxide semiconductor layer 14 may be formed to have an ultra-thin thickness through an atomic layer deposition (ALD) method. The ALD method may be performed with a plasma-enhanced chemical vapor deposition (PECVD) process and/or a low-pressure CVD (LPCVD) process; however, example embodiments are not limited thereto. The ALD method may not be performed with a sputtering process such as a physical vapor deposition (PVD) process.

As the ALD method is performed at a higher temperature than a sputtering process and uses a material having a high reactivity as a deposition material, other layers may be affected during the deposition of a target layer. For example, when forming the oxide semiconductor layer 14 on or directly on the metal layer 11 through the ALD method, the oxygen source of the oxide semiconductor layer 14 may react to and/or diffuse to the metal layer 11 adjacent thereto, and the interfacial resistance may increase, e.g. in a conventional process.

The thin-film structure 10 according to some example embodiments may include the metal oxide layer 12 and the metal nitride layer 13 between the metal layer 11 and the oxide semiconductor layer 14 so as to improve performance of the semiconductor device. For example, due to the low reactivity of the metal nitride layer 13 to oxygen, the oxygen source may not pass or may not diffuse through the metal nitride layer 13, and accordingly, the reaction between the metal layer 11 and the oxygen source may be substantially prevented or reduced in likelihood of occurrence and/or of impact from occurrence during the process of forming the oxide semiconductor layer 14 and/or manufacturing a semiconductor device or an electronic apparatus including the thin-film structure 10. Alternatively or additionally, a metal included in the metal nitride layer 13 may have a higher reactivity to oxygen than a metal included in the metal layer 11, and movement or diffusion of oxygen may be limited.

The thickness of the metal layer 11 may be about 20 nm or less. For example, the thickness of the metal layer 11 may be about 1 nm or more, about 3 nm or more, or about 5 nm or more, and may be about 15 nm or less, about 10 nm or less, or about 7 nm or less.

The thickness of the metal oxide layer 12 may be about 5 nm or less. For example, the thickness of the metal oxide layer 12 may be about 0.1 nm or more, about 0.5 nm or more, or about 1 nm or more, and may be about 3 nm or less, about 3.5 nm or less, about 4 nm or less, or about 5 nm or less. Or, the thickness of the metal oxide layer 12 may be about 0.5 nm to about 3.5 nm.

The thickness of the metal nitride layer 13 may be about 10 nm or less. The thickness of the metal nitride layer 13 may be about 0.1 nm or more, about 0.3 nm or more, about 0.5 nm or more, about 0.8 nm or more, or about 1 nm or more, and may be about 8 nm or less, about 7 nm or less, about 6 nm or less, or about 5 nm or less.

The thickness of the oxide semiconductor layer 14 may be about 10 nm or less, about 8 nm or less, or about 7 nm or less.

The thickness of each of the metal layer 11, the metal oxide layer 12, the metal nitride layer 13, and the oxide semiconductor layer 14 may refer to an average thickness.

The thickness of the metal layer 11, the metal oxide layer 12, the metal nitride layer 13, and the oxide semiconductor layer 14 may be measured from energy dispersive X-ray spectroscopy (EDS). More specifically, the thickness of the metal layer 11, the metal oxide layer 12, the metal nitride layer 13, and the oxide semiconductor layer 14 may be measured from a thickness of an area from which elements constituting each of the metal layer 11, the metal oxide layer 12, the metal nitride layer 13, and the oxide semiconductor layer 14 are detected. For example, when the metal oxide layer 12 includes a tungsten oxide, an area from which tungsten and oxygen are simultaneously detected according to an EDS analysis result may be considered as the thickness of the tungsten oxide. Alternatively or additionally, an area in which the content of tungsten decreases drastically and simultaneously the content of oxygen increases sharply according to an EDS analysis result may be considered as the thickness of the tungsten oxide.

The thin-film structure 10 according to some example embodiments may have a proper thickness ratio among the metal layer 11, the metal oxide layer 12, the metal nitride layer 13, and the oxide semiconductor layer 14. As the metal oxide layer 12 has high resistance characteristics when its thickness is greater than or equal to a certain value, the characteristics of a semiconductor device may be deteriorated. For example, the density of an on current flowing in the metal layer 11 and the oxide semiconductor layer 14 may decrease drastically. The thickness of the metal nitride layer 13 may control the thickness of the metal oxide layer 12. For example, the greater the thickness of the metal nitride layer 13 is, the thinner the thickness of the metal oxide layer 12 may be. As a greater thickness of the metal nitride layer 13 leads to an increased size of the thin-film structure 10 or a semiconductor device including the thin-film structure 10, the thickness of the metal nitride layer 13 may be up to one times the thickness of the oxide semiconductor layer 14.

The thickness of the metal oxide layer 12 may be less than the thickness of the metal layer 11. The thickness of the metal oxide layer 12 may be less than or equal to about 25 %, less than or equal to about 20 %, or less than or equal to about 18 % of the thickness of the metal layer 11, and may be greater than or equal to 1 % of the thickness of the metal layer 11.

The thickness of the metal oxide layer 12 may be up to about 5 times the thickness of the oxide semiconductor layer 14. The thickness of the metal oxide layer 12 may be up to about 3 times, about 2 times, about 1.5 times, about 1.0 times, or about 0.5 times the thickness of the oxide semiconductor layer 14, and may be greater than or equal to about 1 %, about 5 %, or about 10 % of the thickness of the oxide semiconductor layer 14.

The thickness of the metal oxide layer 12 may be up to 10 times the thickness of the metal nitride layer 13. The thickness of the metal oxide layer 12 may be up to about 5 times, about 2.5 times, about 2 times, or about 1 time the thickness of the metal nitride layer 13, and may be at least about 0.05 times, about 0.1 times, or about 0.2 times the thickness of the metal nitride layer 13. Alternatively, the thickness of the metal oxide layer 12 may be about 0.2 times to about 2 times the thickness of the metal nitride layer 13.

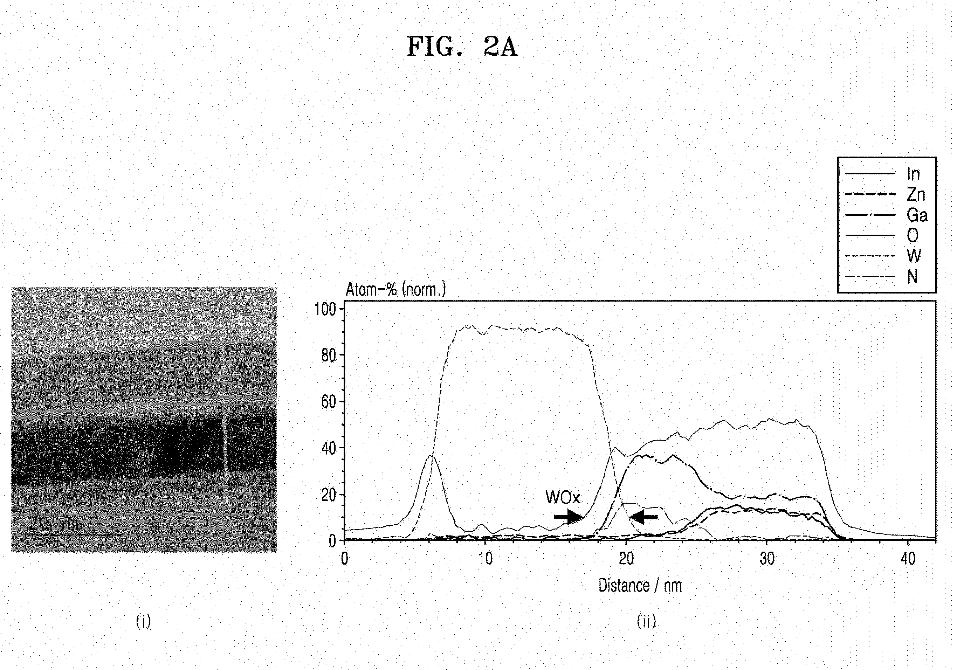

FIGS. 2A to 2C show TEM images and EDS analysis results of a thin-film structure formed by using the ALD method according to some example embodiments. More specifically, it was confirmed that the thin-film structure according to various example embodiments sequentially includes a metal layer including tungsten (W), a metal oxide layer including tungsten-oxide (WOx), a metal nitride layer including GaON, and an oxide semiconductor layer including InGaZnO.

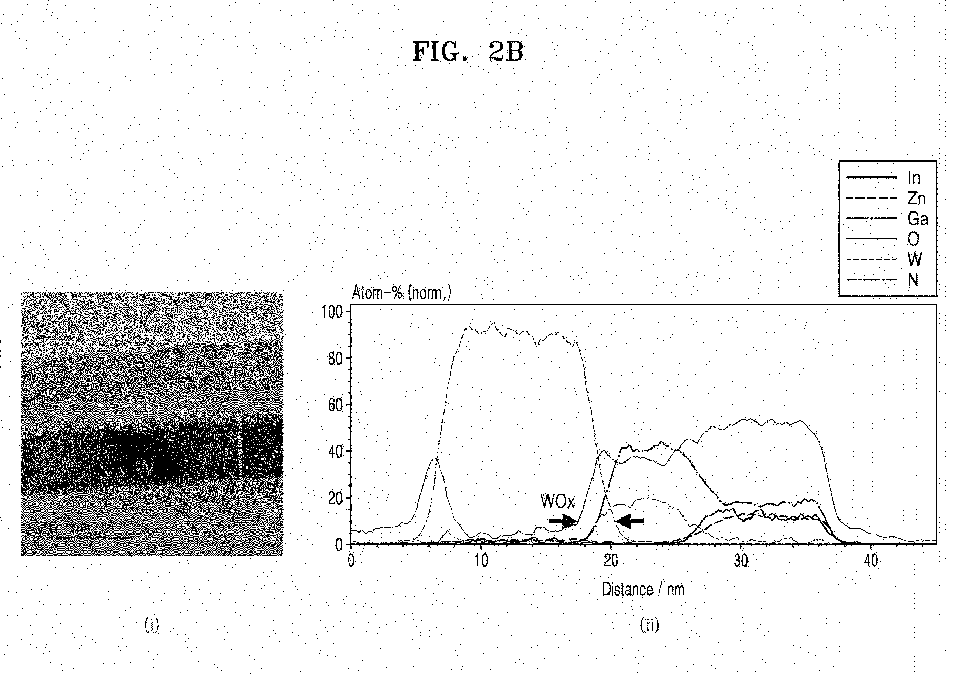

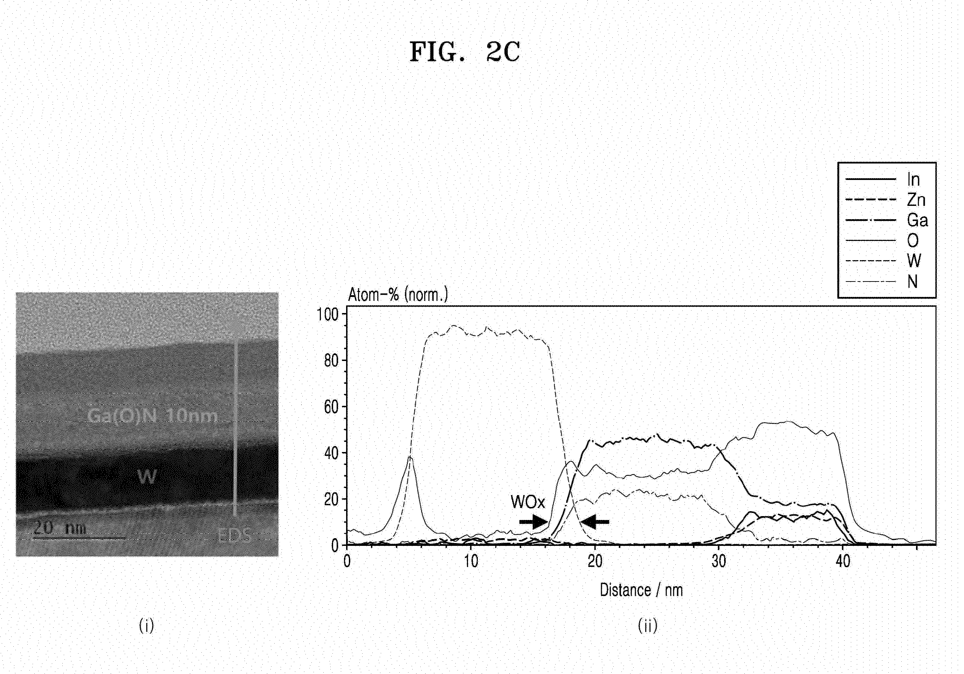

FIGS. 2A to 2C show TEM images and EDS analysis results of the case in which an oxide semiconductor layer including InGaZnO and having the thickness of 10 nm is formed on a metal layer including W, and the thickness of a metal oxide layer including WOx is different from the thickness of a metal nitride layer including GaON. More specifically, FIGS. 2A, 2B, and 2C show (1) TEM images and (ii) EDS analysis of a thin-film structure including a metal nitride layer including GaON and having the thickness of about 3 nm, about 5 nm, and about 10 nm, respectively, wherein the thickness of a metal oxide layer including WOx is controlled. As shown in FIGS. 2A, 2B, and 2C, in the thin-film structure, the greater the thickness of the metal nitride layer including GaON is, the less the thickness of the metal oxide layer including WOx is. Accordingly, when forming the thin-film structure by the ALD method, the thickness of the metal oxide layer may be adjusted to be about 5 nm or less by controlling the thickness of the metal nitride layer.

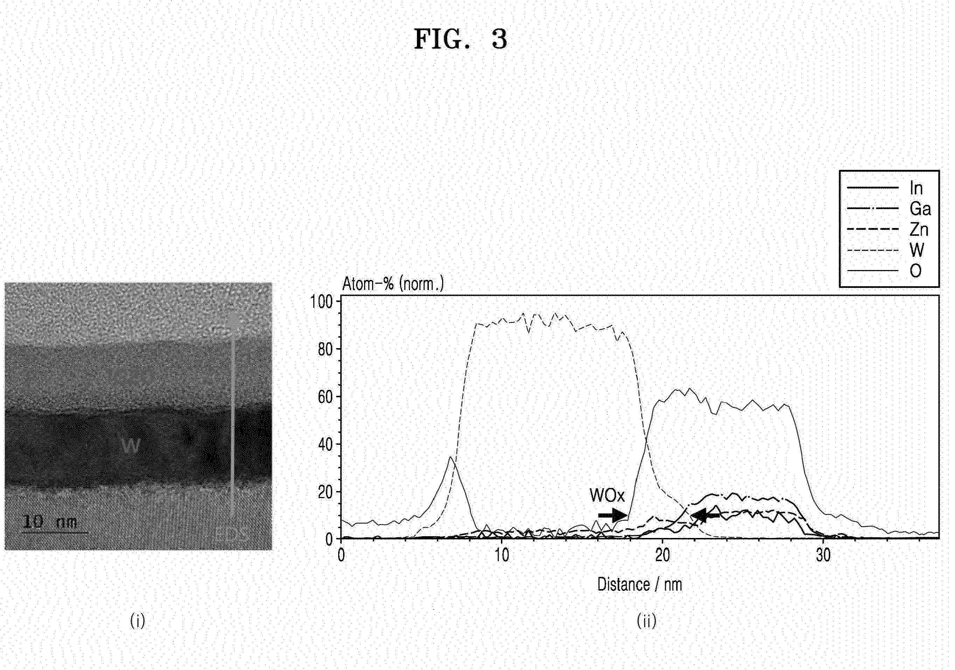

As Comparative Example, FIG. 3 shows a TEM image and an EDS analysis result regarding a thin-film structure in which an oxide semiconductor layer including InGaZnO and having the thickness of 10 nm is formed on a metal layer including W, and a metal oxide layer including WOx is included without a metal nitride layer including GaON.

Referring to FIG. 3, the metal oxide layer of the thin-film structure of Comparative Example has a greater thickness than those of the thin-film structures of FIGS. 2A, 2B, and 2C. The average thickness of the metal oxide layer, e.g., the WOx layer, is greater than about 5 nm. When the thickness of the metal oxide layer increases, the contact resistance between the metal layer and the oxide semiconductor layer may also increase. This may be deleterious to the speed and/or other performance of the semiconductor device.

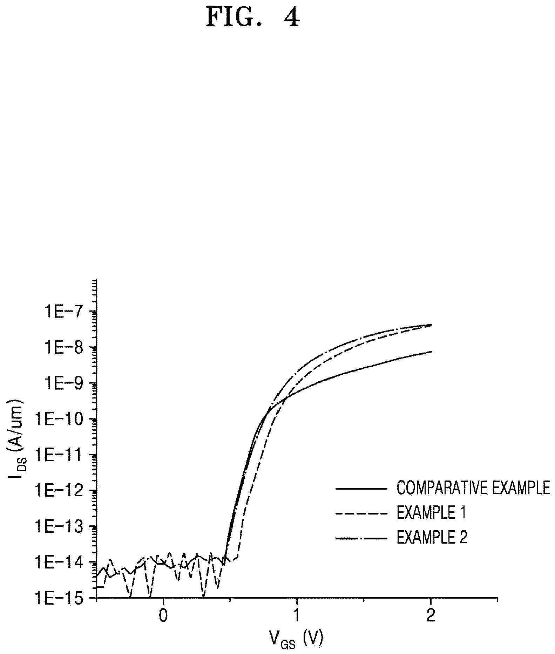

FIG. 4 is a graph showing current-voltage (IV) characteristics of a transistor according to Examples and Comparative Example. Each transistor may include a thin-film structure manufactured by the same method as in FIGS. 2B, 2C, and 3, wherein the metal layer corresponds to a source electrode. W was used for a source/drain electrode, and an oxide semiconductor layer including IGZO was used as a channel layer of a transistor. Comparative Example shows IV characteristics of a transistor including a metal layer, a metal oxide layer, and a oxide semiconductor layer, Example 1 shows IV characteristics of a transistor including a metal layer, a metal oxide layer, a metal nitride layer having a thickness of about 5 nm, and an oxide semiconductor layer, and Example 2 shows IV characteristics of a transistor including a metal layer, a metal oxide layer, a metal nitride layer having a thickness of about 10 nm, and an oxide semiconductor layer.

Referring to FIG. 4, the IV characteristics of the transistors according to Examples 1 and 2 were improved more than the IV characteristics of the transistor according to Comparative Example. Moreover, the IV characteristics of the transistor were improved according to the thickness of the metal nitride layer and the metal oxide layer.

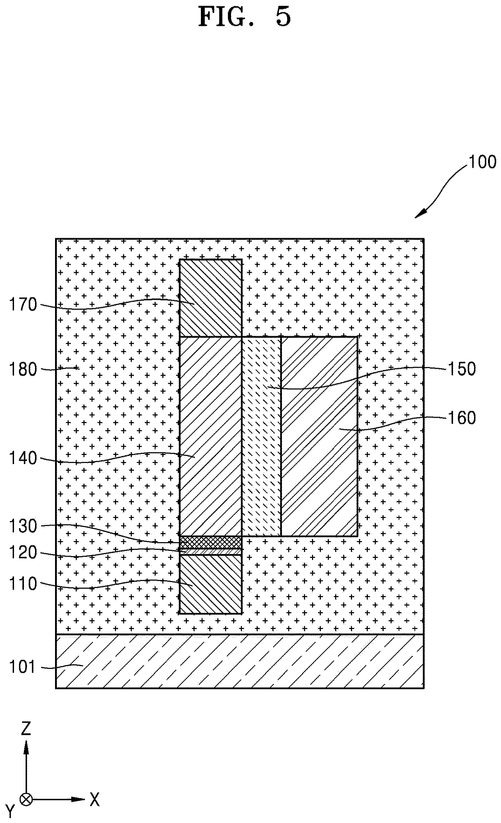

FIG. 5 is a diagram illustrating a semiconductor device 100 including a metal oxide layer 120 and a metal nitride layer 130 according to some example embodiments. Referring to FIG. 5, the semiconductor device 100 may include the substrate 101, a first electrode 110 arranged on the substrate 101, the metal oxide layer 120 arranged on the first electrode 110, the metal nitride layer 130 arranged on the metal oxide layer 120, and an oxide semiconductor layer 140 arranged on the metal nitride layer 130.

The substrate 101 may be or may include or be included an insulating substrate or a semiconductor substrate on which an insulating layer is formed. Or, the substrate 101 may be, include, or be included in a semiconductor substrate. The semiconductor substrate may include, for example, one or more of Si, Ge, SiGe, or Group III-V semiconductor materials. The substrate 101 may be, for example, a silicon substrate on which a silicon oxide is formed; however, example embodiments are not limited thereto.

The first electrode 110, the metal oxide layer 120, the metal nitride layer 130, and the oxide semiconductor layer 140 may correspond to the thin-film structure 10 described above in relation to FIG. 1.

For example, the first electrode 110 may include a metallic material. The first electrode 110 may include at least one selected from among W, Co, Ni, Fe, Ti, Mo, Cr, Zr, Hf, Nb, Ta, Ag, Au, Al, Cu, Sn, V, Ru, Pt, An, and Mg. The first electrode 110 may be arranged apart from the substrate 101.

A metal included in the metal oxide layer 120 may be identical to a metal included in the first electrode 110. The thickness of the metal oxide layer 120 may be less than the thickness of the first electrode 110. The thickness of the metal oxide layer 120 may be about 5 nm or less.

The content of oxygen included in the metal oxide layer 120 may be changed as a distance to the oxide semiconductor layer 140 increases. For example, the content of oxygen included in the metal oxide layer 120 may decrease as a distance to oxide semiconductor layer 140 increases. An interface between the first electrode 110 and the metal oxide layer 120 may be unclear or may not be present or may be amorphous. For example, the metal oxide layer 120 may be formed as a part of the first electrode 110. The metal oxide layer 120 may be formed discontinuously or continuously on the first electrode 110.

The electrical conductivity of the metal nitride layer 130 may be greater than the electrical conductivity of the oxide semiconductor layer 140 and may be less than the electrical conductivity of the first electrode 110. A metal included in the conductive metal nitride layer 130 may be different from a metal included in the first electrode 110. The metal nitride layer 130 may include a metal which has a low reactivity to oxygen and remains stable or a metal which has a higher oxidation reactivity than a metal included in the first electrode 110 yet remains conductive even when the metal is oxidized. The metal nitride layer 130 may include at least one of Ga, Mo, W, Zn, V, and Ti.

The metal nitride layer 130 may further include oxygen. The content of oxygen included in the metal nitride layer 130 (at%) may be greater than or equal to the content of oxygen included in the metal oxide layer 120. Alternatively or additionally, the content of oxygen included in the metal nitride layer 130 (at%) may be less than or equal to the content of oxygen included in the oxide semiconductor layer 140.

The thickness of the metal nitride layer 130 may be greater than or equal to the thickness of the metal oxide layer 120. For example, the thickness of the metal nitride layer 130 may be about 10 nm or less. Or, the thickness of the metal nitride layer 130 may be about 0.1 nm to about 10 nm. A cross-sectional area of the metal nitride layer 130 may be greater than or equal to a cross-section area of the metal oxide layer 120. A width of the metal nitride layer 130 may be greater than or equal to a width of the metal oxide layer 120.

The oxide semiconductor layer 140 may be provided in the form of an ultra-thin film. For example, the thickness of oxide semiconductor layer 140 may be about 10 nm or less. The length of the oxide semiconductor layer 140 may be less than about 1 micron. The oxide semiconductor layer 140 according to some example embodiments may include one or more oxides of one or more materials selected from one or more of the Groups 12, 13, and 14 elements such as Zn, In, Ga, Sn, Cd, Ge, or Hf, and a combination thereof. For example, the oxide semiconductor layer 140 may include a Zn oxide-based material such as a Zn oxide, an In-Zn oxide, an In-Ga-Zn oxide, etc. For example, the oxide semiconductor layer 140 may have a single layer structure or a multi-layer structure.

The oxide semiconductor layer 140 may be arranged in such a manner that a longitudinal direction thereof is a direction perpendicular to the substrate 101 (Z-axis direction). As used herein, the longitudinal direction may refer to a direction of a greater length of a component illustrated in the drawings.

A second electrode 170 may be arranged on the oxide semiconductor layer 140. The first electrode 110 and the second electrode 170 may be arranged apart from each other in a direction perpendicular to the substrate 101 (Z-axis direction).

For example, the first electrode 110, the metal oxide layer 120, the metal nitride layer 130, the oxide semiconductor layer 140, and the second electrode 170 may be arranged in a line in a direction perpendicular to the substrate 101 or in a thickness direction of the first electrode 110 (Z-axis direction). The first electrode 110, the metal oxide layer 120, the metal nitride layer 130, and the oxide semiconductor layer 140 may be arranged sequentially without no other layer arranged thereamong or therebetween.

The oxide semiconductor layer 140 may be arranged in such a manner that a longitudinal direction thereof is a direction perpendicular to the substrate 101 (Z-axis direction). In the disclosure, the longitudinal direction may refer to a direction of a greater length of a component illustrated in the drawings.

A gate electrode 160 may be arranged on one side of the oxide semiconductor layer 140. A gate insulating layer 150 may be arranged between the oxide semiconductor layer 140 and the gate electrode 160. The gate electrode 160 may be arranged in such a manner that the longitudinal direction thereof (Z-axis direction) is a direction perpendicular to the substrate 101. The oxide semiconductor layer 140, the gate insulating layer 150, and the gate electrode 160 may be arranged in a line in a direction horizontal to the substrate 101 (X-axis direction).

A mold insulating layer 180 may be arranged on the substrate 101 to fill an empty space. The first electrode 110 may be arranged apart from the substrate 101 by the mold insulating layer 180.

As described above, in the semiconductor device 100 according to some example embodiments, the metal nitride layer 130 and the metal oxide layer 120 may be arranged between the first electrode 110 and the oxide semiconductor layer 140, and the thickness of the metal nitride layer 130 and the metal oxide layer 120 may be controlled, e.g., may be more controlled by a process of forming a thin film through ALD and/or a following process.

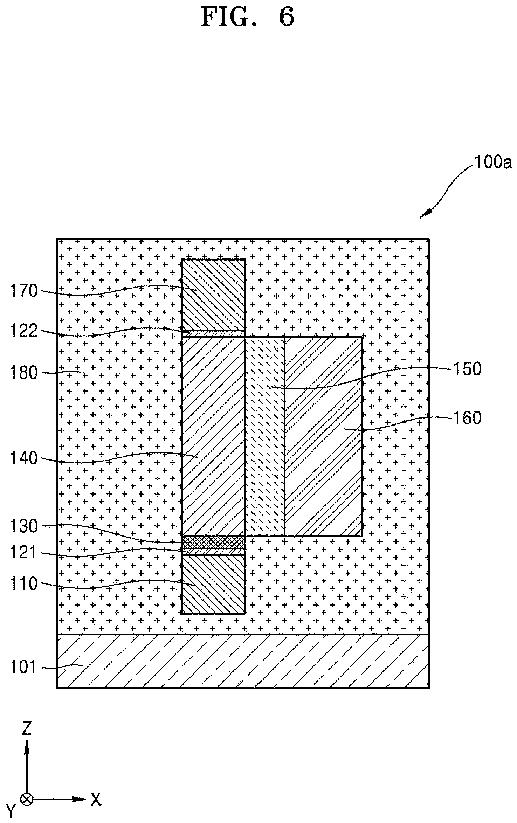

FIG. 6 is a diagram illustrating a semiconductor device 100a according to various example embodiments. In FIG. 6, components denoted by the same reference numerals as in FIG. 5 have substantially the same configuration and effects as described in relation to FIG. 5, and thus any redundant description will be omitted.

When comparing FIGS. 5 and 6, the semiconductor device 100a of FIG. 6 may include a first metal oxide layer 121 arranged between the first electrode 110 and the metal nitride layer 130 and a second metal oxide layer 122 arranged between the oxide semiconductor layer 140 and the second electrode 170.

The first metal oxide layer 121 may correspond to the metal oxide layer 120 described in relation to FIG. 5.

A metal included in the second metal oxide layer 122 may be identical to a metal included in the second electrode 170. The content of oxygen included in the second metal oxide layer 122 may be changed towards the oxide semiconductor layer 140 from the second electrode 170.

The thickness of the second metal oxide layer 122 may be about 5 nm or less. For example, the thickness of the second metal oxide layer 122 may be about 0.1 nm or more, about 0.5 nm or more, or about 1 nm or more, and may be about 3 nm or less, about 3.5 nm or less, about 4 nm or less, or about 5 nm or less. Or, the thickness of the second metal oxide layer 122 may be about 0.5 nm to about 3.5 nm. The thickness of the second metal oxide layer 122 may refer to an average thickness. The thickness of the second metal oxide layer 122 may be the same as or different from (e.g., greater than or less than) the thickness of the first metal oxide layer 121.

The second metal oxide layer 122 may be formed in a process of forming the second electrode 170 on the oxide semiconductor layer 140 and/or in a post treatment process of an apparatus including the semiconductor device 100a of FIG. 6.

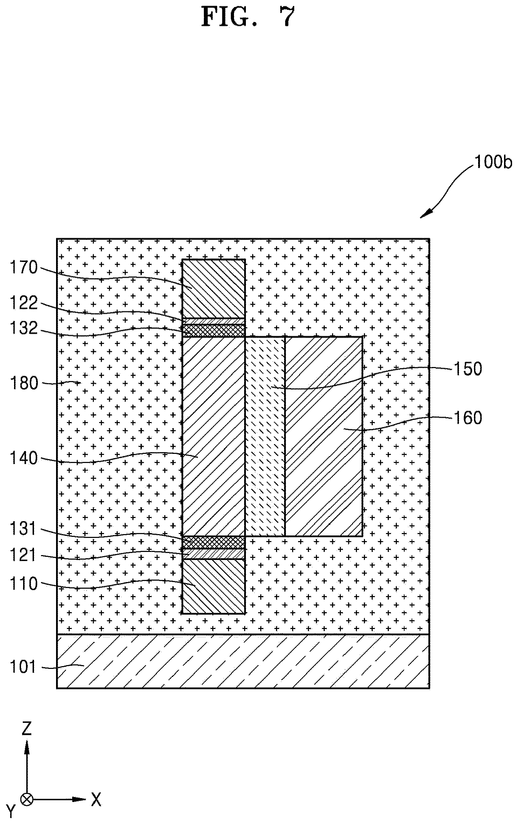

FIG. 7 is a diagram illustrating a semiconductor device 100b according to another embodiment. In FIG. 7, components denoted by the same reference numerals as in FIG. 6 have substantially the same configuration and effects as described in relation to FIG. 6, and thus any redundant description will be omitted.

When comparing FIGS. 6 and 7, the semiconductor device 100b of FIG. 7 may include a first metal nitride layer 131 arranged between the first metal oxide layer 121 and the oxide semiconductor layer 140 and a second metal nitride layer 132 arranged between the oxide semiconductor layer 140 and the second metal oxide layer 122.

The first metal nitride layer 131 may correspond to the metal nitride layer 130 described above in relation to FIGS. 5 and 6.

The electrical conductivity of the second metal nitride layer 132 may be greater than the electrical conductivity of the oxide semiconductor layer 140 and may be less than the electrical conductivity of the second electrode 170. A metal included in the second metal nitride layer 132 may be different from a metal included in the second electrode 170. The second metal nitride layer 132 may include a metal which has a low reactivity to oxygen and remains stable or a metal which has a higher oxidation reactivity than a metal included in the second electrode 170 yet remains conductive even when the metal is oxidized. The second metal nitride layer 132 may include at least one of Ga, Mo, W, Zn, V, and Ti.

The second metal nitride layer 132 may further include oxygen. The content of oxygen included in the second metal nitride layer 132 (at%) may be greater than or equal to the content of oxygen included in the second metal oxide layer 122. The oxygen in the second metal nitride layer 132 may be included during the formation of the second metal oxide layer 122. However, example embodiments are not limited thereto. The oxygen included in the oxide semiconductor layer 140 may be moved and formed (e.g., diffused) in a post treatment process of the semiconductor device 100b of FIG. 7 using heat, etc.

The thickness of the second metal nitride layer 132 may be greater than or equal to the thickness of the second metal oxide layer 122. The thickness of the second metal nitride layer 132 may be at least two times the thickness of the second metal oxide layer 122. The greater the thickness of the second metal nitride layer 132 is, the less the thickness of the second metal oxide layer 122 may be. For example, the thickness of the second metal nitride layer 132 may be about 10 nm or less. Or, the thickness of the second metal nitride layer 132 may be about 0.1 nm to about 10 nm.

A cross-sectional area of the second metal nitride layer 132 may be greater than or equal to a cross-section area of the second metal oxide layer 122. The width of the second metal nitride layer 132 may be greater than or equal to the width of the second metal oxide layer 122. For example, a part of an upper surface of the second metal nitride layer 132 may be in contact with the second metal oxide layer 122, and another part of the upper surface of the second metal nitride layer 132 may be in contact with the second electrode 170.

The second metal nitride layer 132 may control the thickness of the second metal oxide layer 122. For example, the greater the thickness of the second metal nitride layer 132 is, the thinner the thickness of the second metal oxide layer 122 may be. Accordingly, the second metal nitride layer 132 may prevent or reduce the likelihood of and/or impact from an increase in contact resistance between the second electrode 170 and the oxide semiconductor layer 140.

The thickness of the second metal nitride layer 132 may be less than or equal to the thickness of the first metal nitride layer 131, or the thickness of the second metal oxide layer 122 may be less than or equal to the thickness of the first metal oxide layer 121. The first metal nitride layer 131 may be used to control the formation of the first metal oxide layer 121, and the second metal nitride layer 132 may be used to control the formation of the second metal oxide layer 122.

The first metal oxide layer 121 may be formed in a process of forming the oxide semiconductor layer 140, a post treatment process of the semiconductor device 100b, etc., and the second metal oxide layer 122 may be formed in a process of forming the second electrode 170, a post treatment process of the semiconductor device 100b, etc.

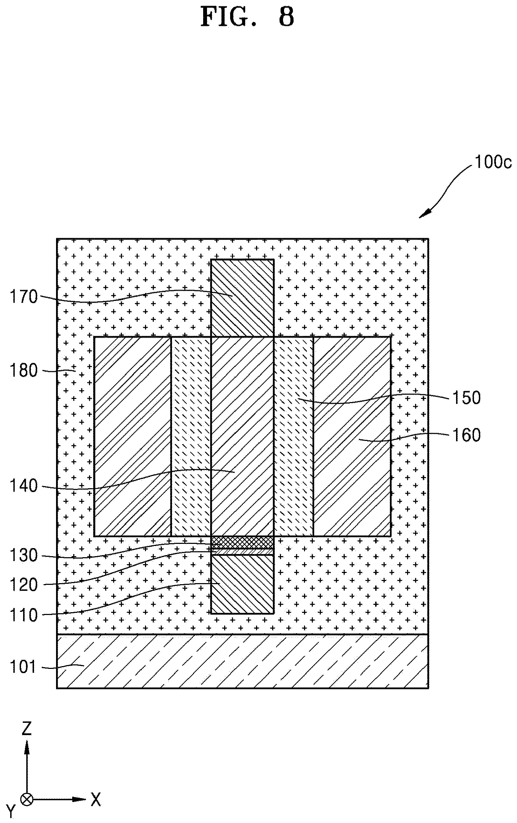

FIG. 8 is a diagram illustrating a semiconductor device 100c according to another embodiment. In FIG. 8, components denoted by the same reference numerals as in FIG. 5 have substantially the same configuration and effects as described in relation to FIG. 5, and thus any redundant description will be omitted.

The semiconductor device 100c illustrated in FIG. 8 may include the first electrode 110, the metal oxide layer 120, the metal nitride layer 130, the oxide semiconductor layer 140, and the second electrode 170 which are arranged in a direction perpendicular to the substrate 101 (Z-axis direction). The gate insulating layer 150 may be arranged on a circumference of the oxide semiconductor layer 140, and the gate electrode 160 may be arranged on a circumference of the gate insulating layer 150. As the gate electrode 160 is arranged on the circumference of the oxide semiconductor layer 140, an area between the gate electrode 160 and the oxide semiconductor layer 140 which face each other, and the short channel effect may be enhanced.

Although it is not shown in the drawings, in the semiconductor device 100c of FIG. 8, a second metal oxide layer may be further arranged between the oxide semiconductor layer 140 and the second electrode 170, or a second metal nitride layer may be further arranged between the oxide semiconductor layer 140 and the second metal oxide layer.

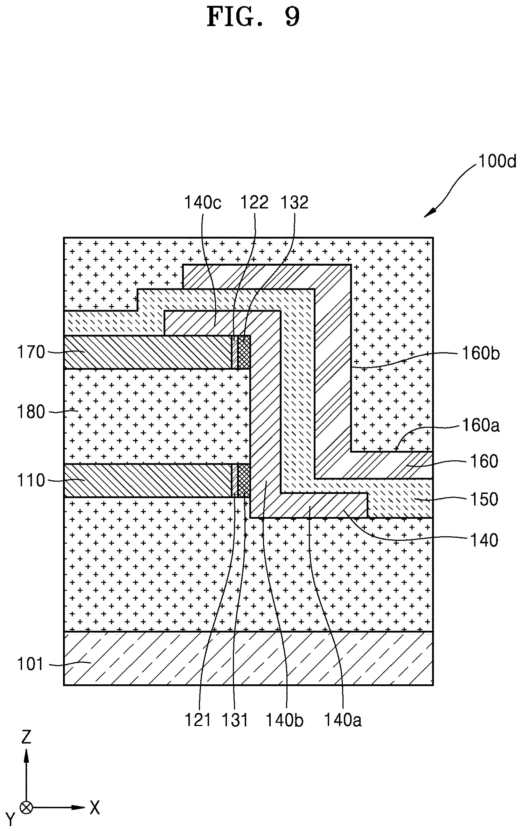

FIG. 9 is a diagram illustrating a semiconductor device 100d according to another embodiment.

Referring to FIG. 9, the semiconductor device 100d may include the substrate 101, the first electrode 110 arranged on the substrate 101, and the second electrode 170 arranged apart from the first electrode 110. The first electrode 110 and the second electrode 170 may be arranged apart from each other in a direction perpendicular to the substrate 101 (Z-axis direction). As the first electrode 110 and the second electrode 170 may correspond to the metal layer 11 described above in relation to FIG. 1, specific descriptions thereon are omitted.

The oxide semiconductor layer 140 may be arranged outside of a space between the first electrode 110 and the second electrode 170. The oxide semiconductor layer 140 may include a first portion 140a parallel with the substrate 101, a second portion 140b bent from the first portion 140a in a direction perpendicular to the substrate 101, and a third portion 140c bent from the second portion 140b and extending in an opposite direction of the first portion 140a. The second portion 140b may be arranged on a side of the first electrode 110 and the second electrode 170, and the third portion 140c may be arranged to be in contact with the second electrode 170. The oxide semiconductor layer 140 may correspond to the oxide semiconductor layer 140 described above in relation to FIG. 1.

The first metal nitride layer 131 may be arranged between the first electrode 110 and the second portion 140b of the oxide semiconductor layer 140, and the first metal oxide layer 121 may be arranged between the first electrode 110 and the first metal nitride layer 131. In addition, the second metal nitride layer 132 may be arranged between the second electrode 170 and the second portion 140b of the oxide semiconductor layer 140, and the second metal oxide layer 122 may be arranged between the second electrode 170 and the second metal nitride layer 132.

The first metal oxide layer 121 and the second metal oxide layer 122 may correspond to the metal oxide layer 120 described above in relation to FIG. 1, and the first metal nitride layer 131 and the second metal nitride layer 132 may correspond to the metal nitride layer 130 described above in relation to FIG. 1.

The gate electrode 160 may have a similar shape to the oxide semiconductor layer 140 and may be arranged apart from the oxide semiconductor layer 140. In other words, the gate electrode 160 may include a first portion 160a parallel with the substrate 101, a second portion 160b bent from the first portion 160a in a direction perpendicular to the substrate 101, and a third portion 160c bent from the second portion 160b and extending in an opposite direction of the first portion 160a. The gate insulating layer 150 may be arranged between the oxide semiconductor layer 140 and the gate electrode 160.

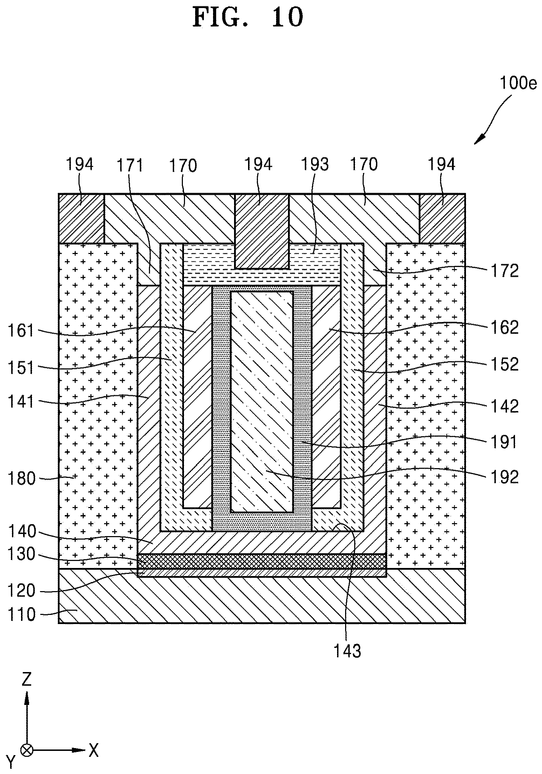

FIG. 10 is a diagram illustrating a semiconductor device 100e according to another embodiment.

The semiconductor device 100e illustrated in FIG. 10 may include the first electrode 110, the metal oxide layer 120 arranged on the first electrode 110, the metal nitride layer 130 arranged on the metal oxide layer 120, and the oxide semiconductor layer 140 arranged on the metal nitride layer 130.

The first electrode 110, the metal oxide layer 120, the metal nitride layer 130, and the oxide semiconductor layer 140 may respectively correspond to the metal layer 11, the metal oxide layer 12, the metal nitride layer 13, and the oxide semiconductor layer 14 described above in relation to FIG. 1, and thus any redundant descriptions thereon will be omitted.

The width of the first electrode 110 may be greater than the width of the metal oxide layer 120. A surface of the first electrode 110 may be stepped by the metal oxide layer 120. An entire are of the oxide semiconductor layer 140 may be arranged to overlap the metal oxide layer 120 in a direction from the oxide semiconductor layer 140 to the first electrode 110.

The oxide semiconductor layer 140 may have a U-shaped cross-section. The oxide semiconductor layer 140 may include a bottom portion 143 in contact with the metal nitride layer 130, a first vertical extension 141 extending from one end of the bottom portion 143 in a direction perpendicular to the first electrode 110 (Z-axis direction), and a second vertical extension 142 extending from the other end of the bottom portion 143 in the direction perpendicular to the first electrode 110 (Z-axis direction).

A first gate electrode 161 may be arranged apart from the first vertical extension 141, and a second gate electrode 162 may be arranged apart from the second vertical extension 142. A first gate insulating layer 151 may be arranged between the first vertical extension 141 and the first gate electrode 161, and a second gate insulating layer 152 may be arranged between the second vertical extension 142 and the second gate electrode 162.

The first gate electrode 161 and/or the second gate electrode 162 may extend in a second horizontal direction (Y-axis direction). The first gate electrode 161 and the second gate electrode 162 may be arranged apart from each other. The first gate electrode 161 and/or the second gate electrode 162 may constitute a word line WL. An electrical signal input to the first gate electrode 161 may not correspond to an electrical signal to the second gate electrode 162. The first gate electrode 161 may control a channel of the first vertical extension 141, and the second gate electrode 162 may control a channel of the second vertical extension 142.

An insulating liner 191 may be arranged between the first gate electrode 161 and the second gate electrode 162 which are arranged apart from each other. The insulating liner 191 may be arranged conformally on side walls of the first gate electrode 161 and the second gate electrode 162, which face each other and/or on an upper surface of the oxide semiconductor layer 140. The insulating liner 191 may include an upper surface arranged on the same plane as the first gate electrode 161 and the second gate electrode 162. The insulating liner 191 may include, for example, a silicon nitride. A buried insulating layer 192 may fill a space between the first gate electrode 161 and the second gate electrode 162 which are arranged apart from each other on the insulating liner 191. The buried insulating layer 192 may include, for example, a silicon oxide. An upper insulating layer 193 may be arranged on upper surfaces of the first gate electrode 161, the second gate electrode 162, and/or the buried insulating layer 192. An upper surface of the upper insulating layer 193 may be arranged at the same level as an upper surface of the mold insulating layer 180.

The second electrode 170 may be arranged on the oxide semiconductor layer 140. The second electrode 170 may function as a landing pad. The second electrode 170 may include a first sub-electrode 171 and a second sub-electrode 172. The first sub-electrode 171 may be electrically connected to the first vertical extension 141. The second sub-electrode 172 may be electrically connected to the second vertical extension 142. The first sub-electrode 171 may not be electrically connected to the second sub-electrode 172.

The second electrode 170 may include an upper portion and a lower portion. The upper portion of the second electrode 170 may be a part of the second electrode 170, which is arranged at a higher level than the upper surface of the mold insulating layer 180. The lower portion of the second electrode 170 may be a part of the second electrode 170, which is arranged in a recess of the second electrode 170 defined between the mold insulating layer 180 and the upper insulating layer 193.

In some example embodiments, the upper portion of the second electrode 170 may have a first width in the first horizontal direction (X-axis direction), and the lower portion of the second electrode 170 may have a second width, which is less than the first width, in the first horizontal direction (X-axis direction). The lower portion of the second electrode 170 may be arranged in the recess of the second electrode 170, and the upper portion of the second electrode 170 may have a bottom surface arranged on upper surfaces of mold insulating layer 180 and the upper insulating layer 193 on the lower portion of the second electrode 170. Accordingly, the second electrode 170 may have a T-shaped vertical cross-section.

The bottom surface of the lower portion of the second electrode 170 may be in contact with an upper surface of the first vertical extension 141 and/or the second vertical extension 142. Both side walls of the lower portion of the second electrode 170 may be aligned with both side walls of the first vertical extension 141 and the second vertical extension 142. The bottom surface of the lower portion of the second electrode 170 may be arranged at a higher level than the upper surface of the first gate electrode 161 and/or the second gate electrode 162, and a part of the side wall of the lower portion of the second electrode 170 may be covered by the first gate insulating layer 151 and/or the second gate insulating layer 152.

A second electrode insulating layer 194 surrounding the periphery of the second electrode 170 may be arranged on the upper surfaces of the mold insulating layer 180 and the upper insulating layer 193. The semiconductor device 100e may have a vertical channel transistor (VCT) structure including a vertical channel region extending in a direction perpendicular to the first electrode 110 (X-axis direction).

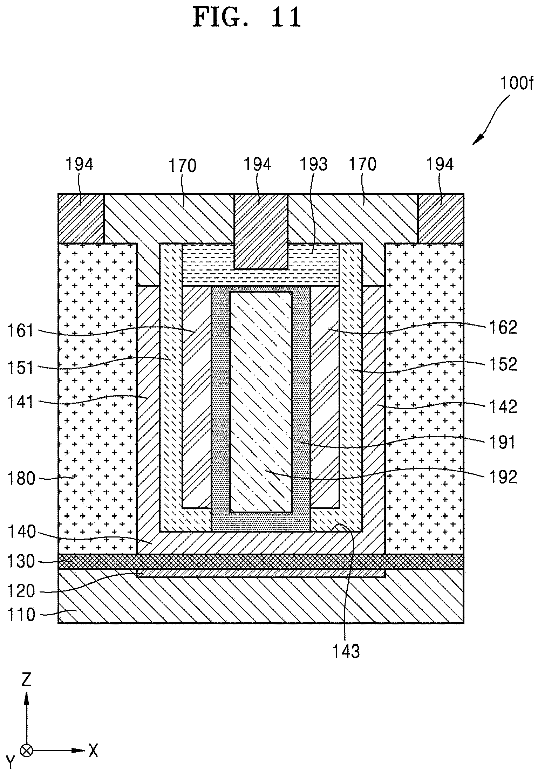

FIG. 11 is a diagram illustrating a semiconductor device 100f according to another embodiment. As components in FIG. 11 that are denoted by the same reference numeral as in FIG. 10 have substantially the same configuration and operational effects, detailed descriptions thereon are omitted.

When comparing FIGS. 10 and 11, the metal nitride layer 130 included in the semiconductor device 100f of FIG. 11 may be arranged over the entire upper surface of the first electrode 110. A bit line may be formed on the first electrode 110, and the metal nitride layer 130 may be arranged along the first electrode 110.

The width of the metal nitride layer 130 may be greater than the width of the metal oxide layer 120. In addition, the width of the metal nitride layer 130 may be greater than the width of the oxide semiconductor layer 140. The width of the oxide semiconductor layer 140 may refer to a width in contact with the metal nitride layer 130. A difference between the width of the metal nitride layer 130 and the width of the oxide semiconductor layer 140 may be greater than or equal to a difference between the metal oxide layer 120 and the oxide semiconductor layer 140.

The metal oxide layer 120 may be arranged between the first electrode 110 and the metal nitride layer 130. A surface of the first electrode 110 may be stepped by the metal oxide layer 120. A partial area of the metal nitride layer 130 may be in contact with the metal oxide layer 120, and another partial area of the metal nitride layer 130 may be in contact with the first electrode 110. For example, a partial area of the metal nitride layer 130 that is in contact with the oxide semiconductor layer 140 may also be in contact with the metal oxide layer 120, and a partial area of the metal nitride layer 130 that is not in contact with the oxide semiconductor layer 140 may be in contact with the first electrode 110.

The thickness of the first electrode 110 may be about 20 nm or less. For example, the thickness of first electrode 110 may be about 1 nm or more, about 3 nm or more, or about 5 nm or more, and may be about 15 nm or less, about 10 nm or less, or about 7 nm or less.

The thickness of the metal oxide layer 120 may be about 5 nm or less. For example, the thickness of the metal oxide layer 120 may be about 0.1 nm or more, about 0.5 nm or more, or about 1 nm or more, and may be about 3 nm or less, about 4 nm or less, or about 5 nm or less.

The thickness of the metal nitride layer 130 may be about 10 nm or less. The thickness of the metal nitride layer 130 may be about 0.1 nm or more, about 0.3 nm or more, about 0.5 nm or more, about 0.8 nm or more, or about 1 nm or more, and may be about 8 nm or less, about 7 nm or less, about 6 nm or less, or about 5 nm or less.

The thickness of the oxide semiconductor layer 140 may be about 10 nm or less, about 8 nm or less, or about 7 nm or less.

The first electrode 110, the metal oxide layer 120, the metal nitride layer 130, and the oxide semiconductor layer 140 may have a proper thickness ratio.

The thickness of the metal oxide layer 120 may be less than the thickness of the first electrode 110. The thickness of the metal oxide layer 120 may be less than or equal to about 25 %, less than or equal to about 20 %, or less than or equal to about 18 % of the thickness of the first electrode 110, and may be greater than or equal to 1 % of the thickness of the first electrode 110.

The thickness of the metal oxide layer 120 may be up to about 5 times the thickness of the oxide semiconductor layer 140. The thickness of the metal oxide layer 120 may be up to about 3 times, about 2 times, about 1.5 times, about 1.0 times, or about 0.5 times the thickness of the oxide semiconductor layer 140, and may be greater than or equal to about 1 % of the thickness of the oxide semiconductor layer 140.

The thickness of the metal oxide layer 120 may be up to 10 times the thickness of the metal nitride layer 130. The thickness of the metal oxide layer 120 may be up to about 5 times, about 2.5 times, about 2 times, or about 1 time the thickness of the metal nitride layer 130, and may be at least about 0.05 times, about 0.1 times, or about 0.2 times the thickness of the metal nitride layer 130. Alternatively, the thickness of the metal oxide layer 120 may be about 0.2 times to about 2 times the thickness of the metal nitride layer 130.

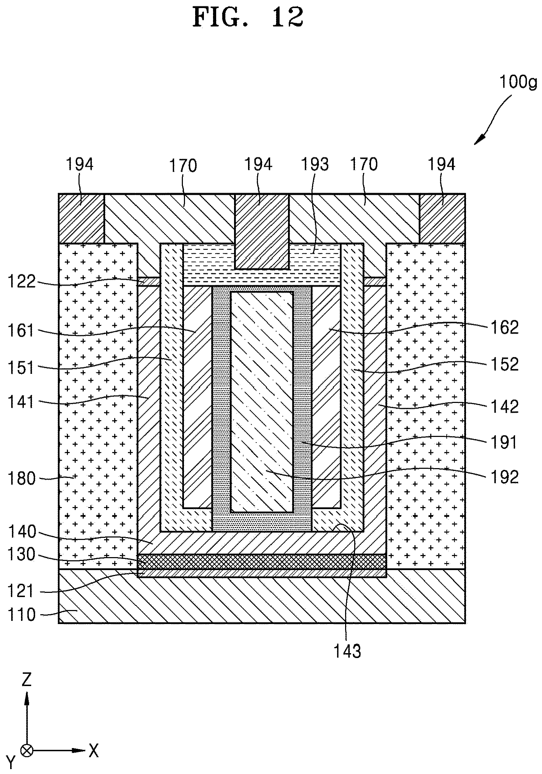

FIG. 12 is a diagram illustrating a semiconductor device 100g according to another embodiment. As components in FIG. 12 that are denoted by the same reference numeral as in FIG. 10 have substantially the same configuration and operational effects, detailed descriptions thereon are omitted.

When comparing FIGS. 10 and 12, the semiconductor device 100g of FIG. 12 may include the first metal oxide layer 121 arranged between the first electrode 110 and the metal nitride layer 130 and the second metal oxide layer 122 arranged between the oxide semiconductor layer 140 and the second electrode 170.

The first metal oxide layer 121 may correspond to the metal oxide layer 120 described in relation to FIG. 10, and thus, specific descriptions thereon are omitted.

A metal included in the second metal oxide layer 122 may be identical to a metal included in the second electrode 170. The content of oxygen included in the second metal oxide layer 122 may be changed as a distance to the oxide semiconductor layer 140 increases. For example, the content of oxygen included in the second metal oxide layer 122 may decrease as a distance to oxide semiconductor layer 140 increases. The thickness of the second metal oxide layer 122 may be about 5 nm or less. For example, the thickness of the second metal oxide layer 122 may be about 0.1 nm or more, about 0.5 nm or more, or about 1 nm or more, and may be about 3 nm or less, about 4 nm or less, or about 5 nm or less.

The second metal oxide layer 122 may be formed in a process of forming the second electrode 170 on the oxide semiconductor layer 140 or in a post treatment process of an apparatus including the semiconductor device 100g of FIG. 12. Accordingly, the second metal oxide layer 122 may have a lower formation probability than the first metal oxide layer 121.

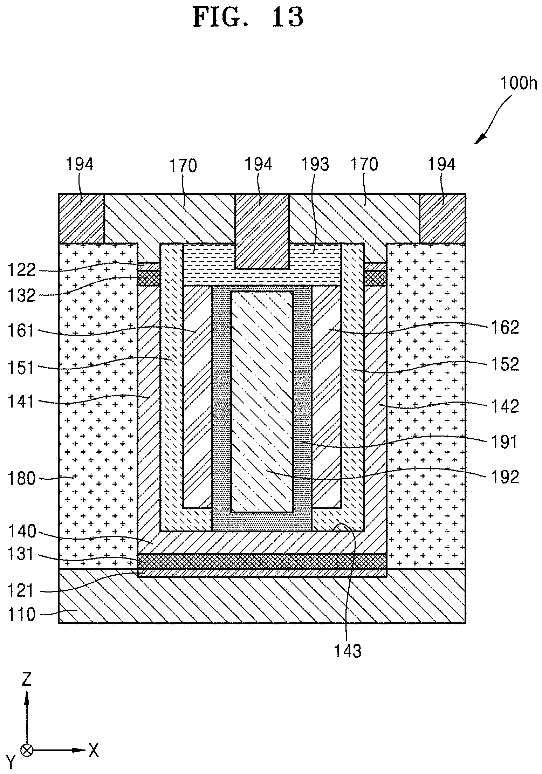

FIG. 13 is a diagram illustrating a semiconductor device 100h according to another embodiment. As components in FIG. 13 that are denoted by the same reference numeral as in FIG. 12 have substantially the same configuration and operational effects, detailed descriptions thereon are omitted.

When comparing FIGS. 12 and 13, the semiconductor device 100h of FIG. 13 may include the first metal nitride layer 131 arranged between the first metal oxide layer 121 and the oxide semiconductor layer 140 and the second metal nitride layer 132 arranged between the oxide semiconductor layer 140 and the second metal oxide layer 122.

The first metal nitride layer 131 may correspond to the metal nitride layer 130 described in relation to FIGS. 10 and 12, and thus, specific descriptions thereon are omitted.

The electrical conductivity of the second metal nitride layer 132 may be greater than the electrical conductivity of the oxide semiconductor layer 140 and may be less than the electrical conductivity of the second electrode 170. A metal included in the second metal nitride layer 132 may be different from a metal included in the second electrode 170. The second metal nitride layer 132 may include a metal which has a low reactivity to oxygen and remains stable or a metal which has a higher oxidation reactivity than a metal included in the second electrode 170 yet remains conductive even when the metal is oxidized.

The second metal nitride layer 132 may further include oxygen. The content of oxygen included in the second metal nitride layer 132 (at%) may be greater than or equal to the content of oxygen included in the second metal oxide layer 122. The oxygen in the second metal nitride layer 132 may be included during the formation of the second metal oxide layer 122. However, the disclosure is not limited thereto. The oxygen included in the oxide semiconductor layer 140 may be moved and included in the second metal nitride layer 132 during a post treatment process of the semiconductor device 100h of FIG. 13 using heat, etc.

The thickness of the second metal oxide layer 122 may be up to 10 times the thickness of the second metal nitride layer 132. The thickness of the second metal oxide layer 122 may be up to about 5 times, about 2.5 times, about 2 times, or about 1 time the thickness of the second metal nitride layer 132, and may be at least about 0.05 times, about 0.1 times, or about 0.3 times the thickness of the second metal nitride layer 132.

A cross-sectional area of the second metal nitride layer 132 may be greater than or equal to a cross-section area of the second metal oxide layer 122. The width of the second metal nitride layer 132 may be greater than or equal to the width of the second metal oxide layer 122. For example, a part of an upper surface of the second metal nitride layer 132 may be in contact with the second metal oxide layer 122, and another part of the upper surface of the second metal nitride layer 132 may be in contact with the second electrode 170.

The second metal nitride layer 132 may control the thickness of the second metal oxide layer 122. For example, the greater the thickness of the second metal nitride layer 132 is, the thinner the thickness of the second metal oxide layer 122 may be. Accordingly, the second metal nitride layer 132 may prevent and/or reduce the likelihood of and/or impact from an increase in contact resistance between the second electrode 170 and the oxide semiconductor layer 140.

The thickness of the second metal nitride layer 132 may be less than or equal to the thickness of the first metal nitride layer 131, or the thickness of the second metal oxide layer 122 may be less than or equal to the thickness of the first metal oxide layer 121. The first metal nitride layer 131 may be used to control the formation of the first metal oxide layer 121, and the second metal nitride layer 132 may be used to control the formation of the second metal oxide layer 122.

The first metal oxide layer 121 may be formed in a process of forming the oxide semiconductor layer 140 or a post treatment process of the semiconductor device 100h, and the second metal oxide layer 122 may be formed in a process of forming the second electrode 170 or a post treatment process of the semiconductor device. Thus, the thickness of the second metal oxide layer 122 may be less than or equal to the thickness of the first metal oxide layer 121.

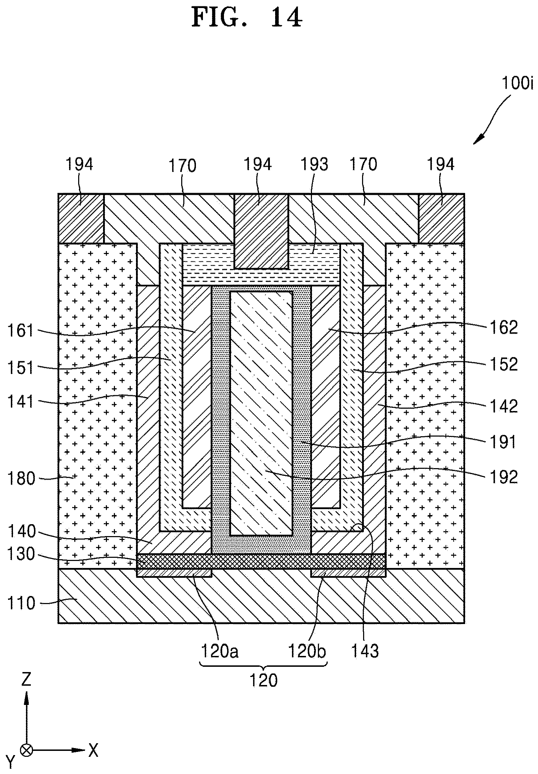

FIG. 14 is a diagram illustrating a semiconductor device 100i according to another embodiment. As components in FIG. 14 that are denoted by the same reference numeral as in FIG. 10 have substantially the same configuration and operational effects, detailed descriptions thereon are omitted.

When comparing FIGS. 10 and 14, the shape of the oxide semiconductor layer 140 included in the semiconductor device 100i of FIG. 14 may be different from the shape of the oxide semiconductor layer 140 included in the semiconductor device 100e of FIG. 10. The semiconductor device 100i may include a first oxide semiconductor layer 141 and a second oxide semiconductor layer 142. The first oxide semiconductor layer 141 may have an L-shape cross-section, and the second oxide semiconductor layer 142 may have a shape that is symmetrical with the first oxide semiconductor layer 141 in the Z-axis direction. The first oxide semiconductor layer 141 and the second oxide semiconductor layer 142 may be separated from each other.

Each of the first oxide semiconductor layer 141 and the second oxide semiconductor layer 142 may be placed in a manner that a longitudinal direction thereof is arranged in a direction perpendicular to a substrate (not shown) (Z-axis direction).

The metal oxide layer may include a first sub-metal oxide layer 120a and a second sub-metal oxide layer 120b which overlap the first oxide semiconductor layer 141 and the second oxide semiconductor layer 142, respectively. The first sub-metal oxide layer 120a and the second sub-metal oxide layer 120b may be separated from each other. However, the disclosure is not limited thereto. The first sub-metal oxide layer 120a and the second sub-metal oxide layer 120b may be connected to each other. For example, the thickness of an overlapping area of the first oxide semiconductor layer 141 and the second oxide semiconductor layer 142 of the metal oxide layer in the thickness direction of the metal oxide layer may be greater than the thickness of a non-overlapping area of the first oxide semiconductor layer 141 and the second oxide semiconductor layer 142 of the metal oxide layer.

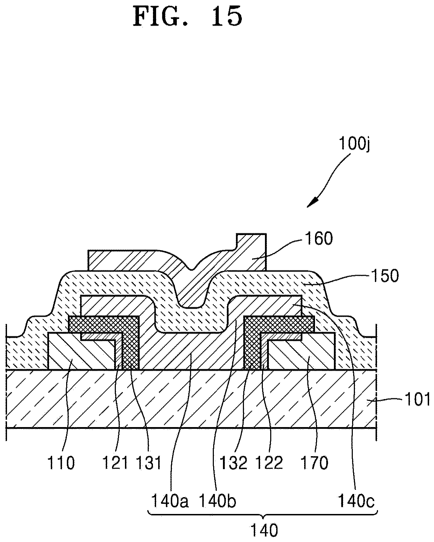

FIG. 15 is a diagram illustrating a semiconductor device 100j according to another embodiment. Referring to FIG. 15, the semiconductor device 100j may include the substrate 101, the first electrode 110, and the second electrode 170, which are arranged apart from each other on the substrate 101. The first electrode 110 and the second electrode 170 may be arranged apart from each other in a direction horizontal with the substrate 101 (X-axis direction). As the first electrode 110 and the second electrode 170 may correspond to the metal layer 11 described above in relation to FIG. 1, specific descriptions thereon are omitted.

The oxide semiconductor layer 140 may be arranged between the first electrode 110 and the second electrode 170. The oxide semiconductor layer 140 may include the first portion 140a parallel with the substrate 101, the second portion 140b bent from the first portion 140a in a direction perpendicular to the substrate 101, and the third portion 140c bent from the second portion 140b and extending in an opposite direction of the first portion 140a. The second portion 140b may overlap a partial area of the first electrode 110 in the thickness direction of the substrate 101, and the third portion 140c may overlap a partial area of the second electrode 170 in the thickness direction of the substrate 101. The oxide semiconductor layer 140 may correspond to the oxide semiconductor layer 140 described above in relation to FIG. 1.

The first metal oxide layer 121 may be arranged between the first electrode 110 and the oxide semiconductor layer 140, and the first metal nitride layer 131 may be arranged between the first metal oxide layer 121 and the oxide semiconductor layer 140. The second metal oxide layer 122 may be arranged between the first metal oxide layer 121 and the oxide semiconductor layer 140, and the second metal nitride layer 132 may be arranged between the second metal oxide layer 122 and the oxide semiconductor layer 140.

A surface of the first electrode 110 may be stepped by the first metal oxide layer 121, and the first metal nitride layer 131 may be arranged to surround a lateral surface and an upper surface of the first metal oxide layer 121. The oxide semiconductor layer 140 may be arranged on a lateral surface and an upper surface of the first metal nitride layer 131.

In the thickness direction of the substrate 101, an overlap ratio between the first metal oxide layer 121 and the oxide semiconductor layer 140 may be different from an overlap ratio between the first metal nitride layer 131 and the oxide semiconductor layer 140. For example, the overlap ratio between the first metal oxide layer 121 and the oxide semiconductor layer 140 may be greater than the overlap ratio between the first metal nitride layer 131 and the oxide semiconductor layer 140.

A surface of the second electrode 170 may also be stepped by the second metal oxide layer 122, and the second metal nitride layer 132 may be arranged to surround a lateral surface and an upper surface of the second metal oxide layer 122. The oxide semiconductor layer 140 may be arranged on a lateral surface and an upper surface of the second metal nitride layer 132.

In the thickness direction of the substrate 101, an overlap ratio between the second metal oxide layer 122 and the oxide semiconductor layer 140 may be different from an overlap ratio between the second metal nitride layer 132 and the oxide semiconductor layer 140. For example, the overlap ratio between the second metal oxide layer 122 and the oxide semiconductor layer 140 may be greater than the overlap ratio between the second metal nitride layer 132 and the oxide semiconductor layer 140.

The first electrode 110, the first metal oxide layer 121, and the first metal nitride layer 131 may respectively correspond to the metal layer 11, the metal oxide layer 12, and the metal nitride layer 13 described in relation to FIG. 1, and the second electrode 170, the second metal oxide layer 122, and the second metal nitride layer 132 may respectively correspond to the metal layer 11, the metal oxide layer 12, and the metal nitride layer 13 described in relation to FIG. 1.

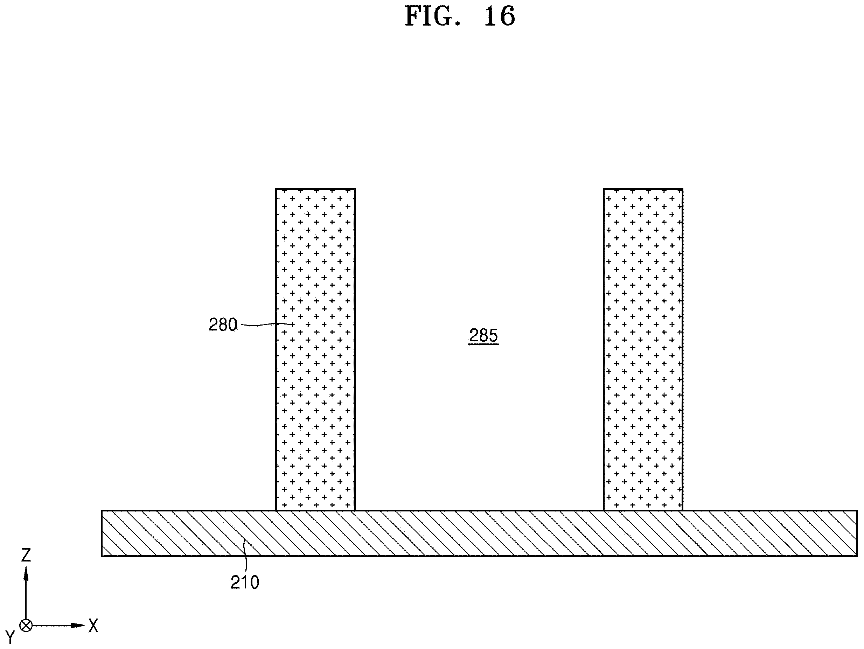

Hereinafter, a method of manufacturing a semiconductor device according to some example embodiments is described in relation to FIGS. 16 to 24.

Referring to FIG. 16, a plurality of mold insulating layers 280 extending in a second horizontal direction (Y-axis direction) may be deposited on a first electrode 210 extending in a first horizontal direction (X-axis direction). The mold insulating layers 280 may be stacked in a vertical direction (Z-axis direction) to have a certain height. The plurality of mold insulating layers 280 and the first electrode 210 may form an opening 285.

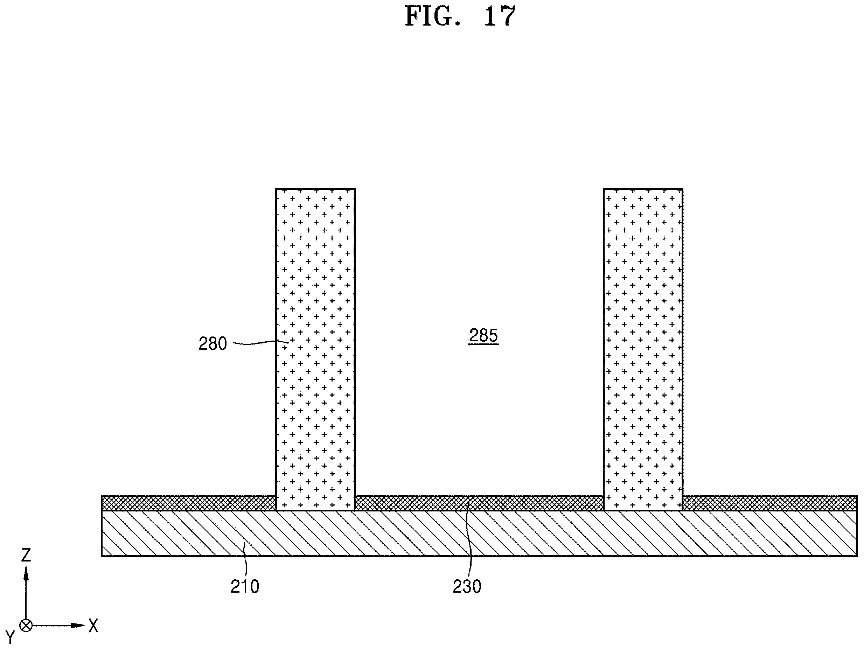

Referring to FIG. 17, a metal nitride layer 230 may be deposited on the first electrode 210. The metal nitride layer 230 may be deposited by using a selective ALD process and/or a PE-ALD process. The metal nitride layer 230 may have a thickness of about 10 nm or less. For example, the metal nitride layer 230 may have a thickness of about 2 nm to about 7 nm.

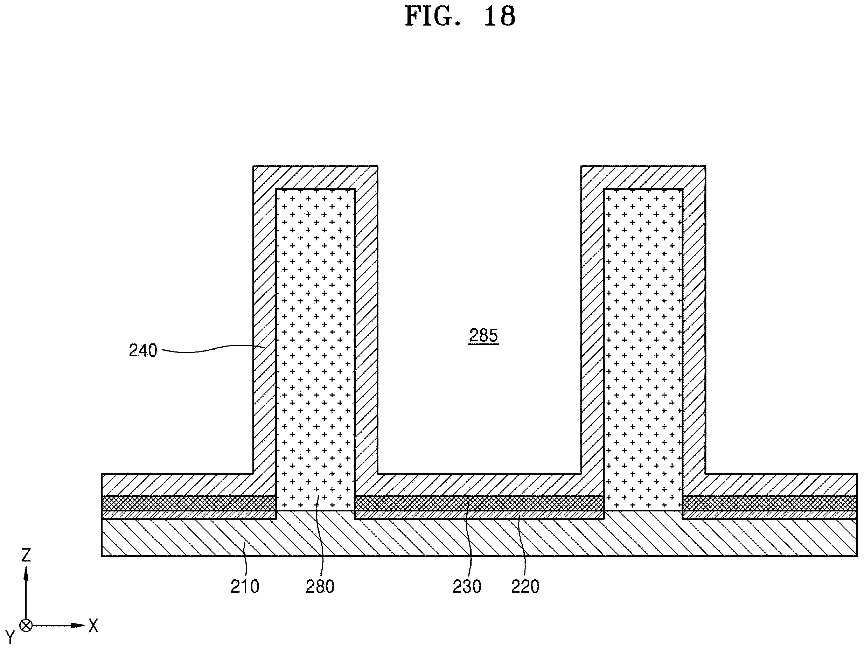

Referring to FIG. 18, an oxide semiconductor layer 240 may be deposited on the metal nitride layer 230 and the mold insulating layers 280. The oxide semiconductor layer 240 may be deposited by using a thermal-ALD method (e.g., a low-pressure thermal ALD method) and/or the PE-ALD method. The oxide semiconductor layer 240 may have a U-shaped cross-section.

Each of the films deposited in FIGS. 17-20 may be deposited in an in-situ manner, e.g., within the same furnace without opening the furnace door. Alternatively each of the films deposited in FIGS. 17-20 may be deposited in an in-situ manner, e.g., in the same chamber without opening the chamber door. However, example embodiments are not limited thereto.

In the process of depositing the oxide semiconductor layer 240, an oxidation reaction may occur between an oxidant included in a precursor of the oxide semiconductor layer 240 and the first electrode 210, and a metal oxide layer 220 may be formed. Even when the first electrode 210 is oxidized, formation of the metal oxide layer 220 may be limited by the metal nitride layer 230. For example, the thickness of the metal oxide layer 220 may be about 5 nm or less. Some of oxygen included in the oxidant may be left in the metal nitride layer 230 when passing through the metal nitride layer 230, and the other may react to the first electrode 210 to from the metal oxide layer 220.

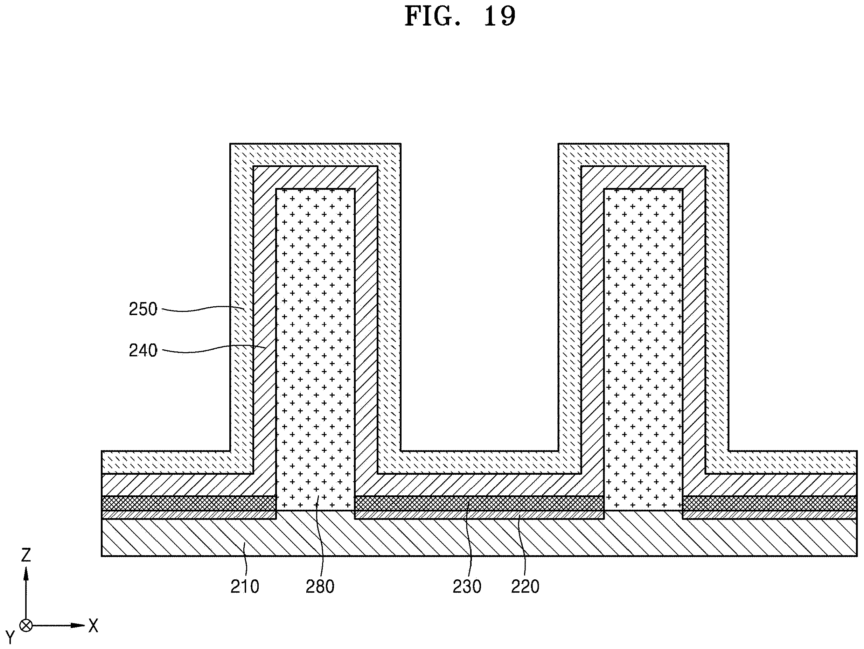

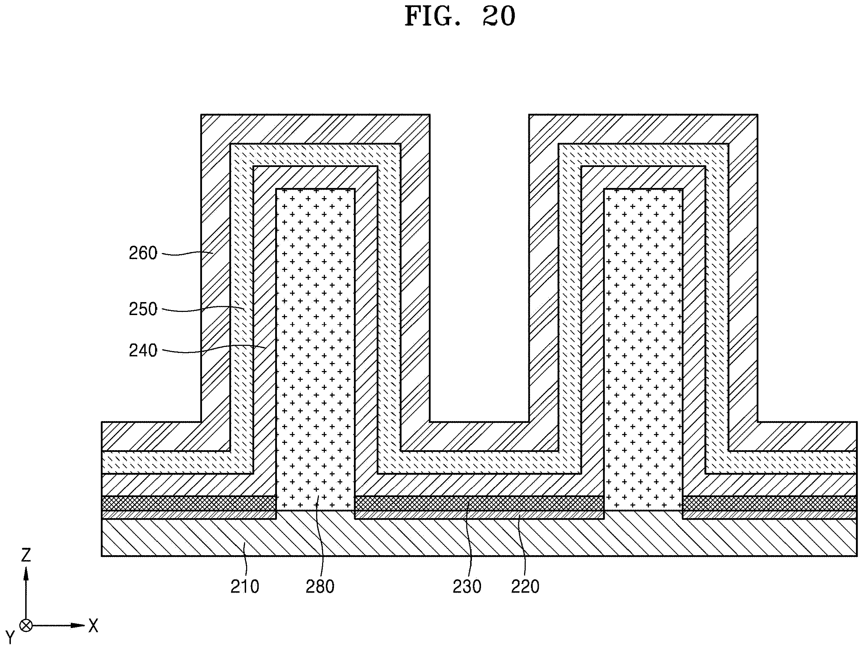

Referring to FIG. 19, a gate insulating layer 250 may be deposited on the oxide semiconductor layer 240. Referring to FIG. 20, a gate electrode 260 may be deposited on the gate insulating layer 250.

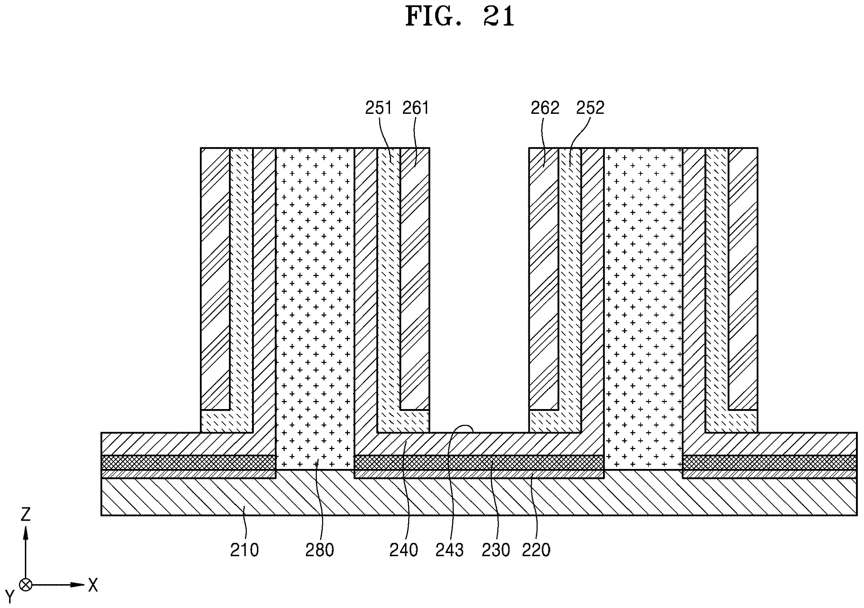

Referring to FIG. 21, etching such as anisotropic etching may be performed on the gate insulating layer 250 and the gate electrode 260 of a structure illustrated in FIG. 20 to expose a bottom portion 243 of the oxide semiconductor layer 240. The gate electrode 260 may be divided into a first gate electrode 261 and a second gate electrode 262, and the gate insulating layer 250 may be divided into a first gate insulating layer 251 and a second gate insulating layer 252.

In addition, the gate electrode 260, the gate insulating layer 250, and the oxide semiconductor layer 240 may be etched in a direction to an upper portion of the mold insulating layers 280 to expose upper surfaces of the mold insulating layers 280. The upper surfaces of the mold insulating layers 280, the upper surfaces of the first gate electrode 261 and the second gate electrode 262, and the upper surfaces of the first gate insulating layer 251 and the second gate insulating layer 252 may be at the same level.

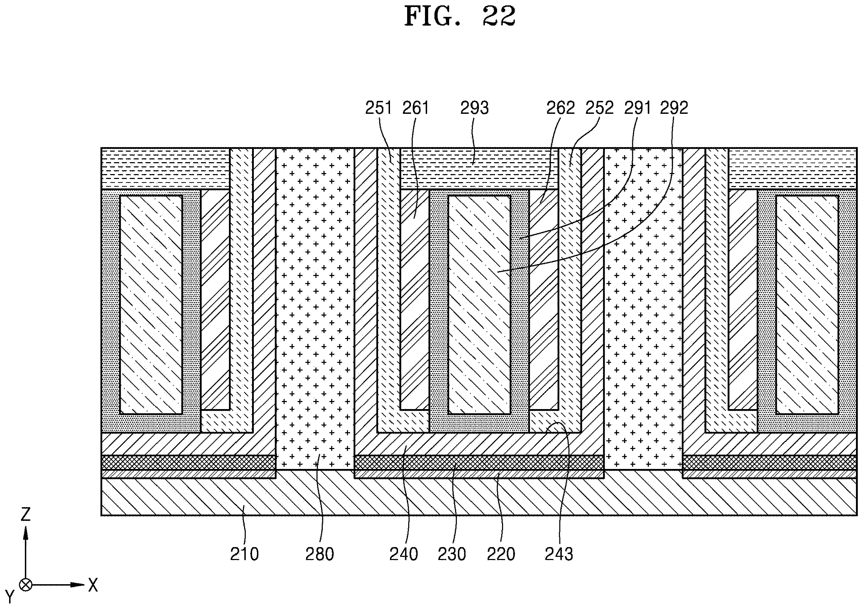

Referring to FIG. 22, when the etching is performed on the gate electrode 260 once more, the level of the upper surface of the first gate electrode 261 and the second gate electrode 262 may be lower than the level of the upper surfaces of the mold insulating layers 280.

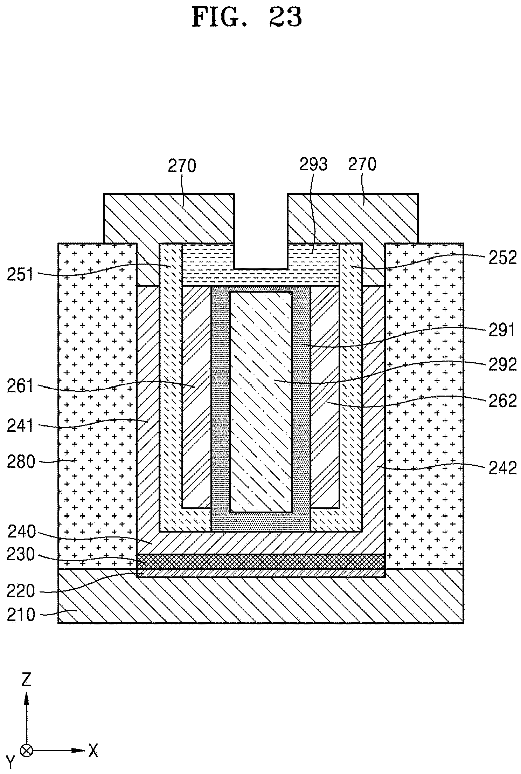

Referring to FIG. 23, an insulating liner 291 may be deposited on a surface of the bottom portion 243 of the oxide semiconductor layer 240 up to a level of an upper surface of the first gate electrode 261 and/or the second gate electrode 262. A buried insulating layer 292 may be filled in the insulating liner 291. The insulating liner 291 and the buried insulating layer 292 may not be distinguished from each other. An upper insulating layer 293 may be deposited on the upper surface of the first gate electrode 261 and/or the second gate electrode 262 and an upper surface of the insulating liner 291. A surface level of the upper insulating layer 293 may correspond to levels of upper surfaces of the mold insulating layers 280, an upper surface of the oxide semiconductor layer 240, upper surfaces of the first gate electrode 261 and the second gate electrode 262, and upper surfaces of the first gate insulating layer 251 and the second gate insulating layer 252.

FIG. 23 illustrates only a part corresponding to one pixel of FIG. 22. Referring to FIG. 23, an upper portion of a first oxide semiconductor layer 241 and an upper portion of a second oxide semiconductor layer 242 may be partially etched, and a second electrode 270 may be deposited on the first oxide semiconductor layer 241 and the second oxide semiconductor layer 242. After depositing the second electrode 270, a central portion of the second electrode 270 and an upper portion of the upper insulating layer 293 may be partially etched.

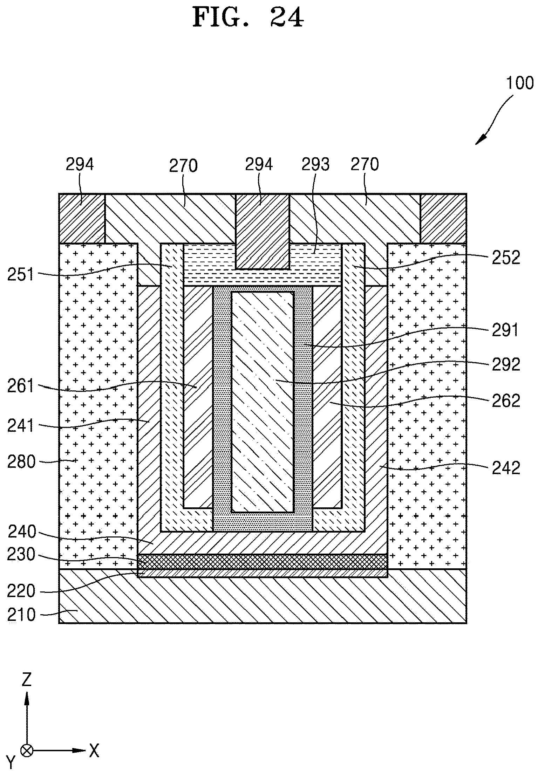

Referring to FIG. 24, a second electrode 294 may be deposited on a part of the upper portion of the upper insulating layer 293 between the second electrodes 270. A level of an upper surface of the second electrode 294 may correspond to a surface level of the second electrode 270.

As a semiconductor device according to some example embodiments is micro-sized and has excellent electrical performance, it may be applied to an integrated circuit device having a high degree of integration.

A semiconductor device according to some example embodiments may be included in a transistor constituting or included in a digital circuit and/or an analog circuit. In some example embodiments, a semiconductor device may be used as a high-voltage transistor and/or a low-voltage transistor. For example, a semiconductor device according to some example embodiments may be included in a high-voltage transistor constituting a peripheral circuit of a flash memory device, an electrically erasable and programmable read-only memory (EEPROM) device, etc., which are a non-volatile memory device operating at a high voltage.

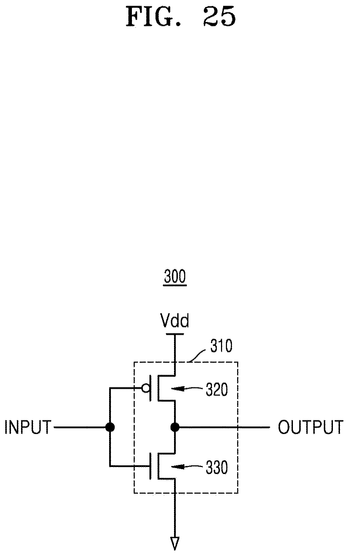

FIG. 25 is a circuit diagram of a complementary metal-oxide semiconductor (CMOS) inverter 300 according to some example embodiments.

The CMOS inverter 300 may include a CMOS transistor 310. The CMOS transistor 310 may include a p-channel metal oxide semiconductor (PMOS) transistor 320 and an n-channel metal oxide semiconductor (NMOS) transistor 330 which are connected between a power terminal Vdd and an earth terminal. The CMOS transistor 310 may include one or more semiconductor devices according to various example embodiments described in relation to FIGS. 5 to 15.

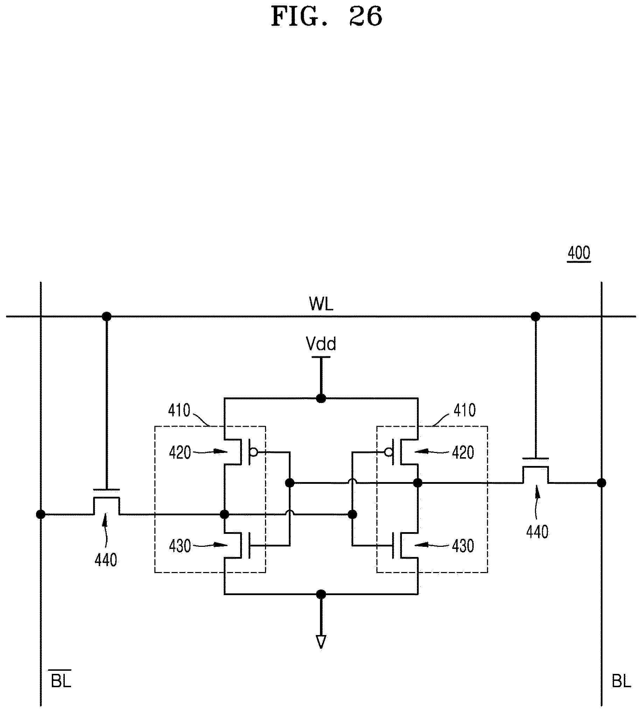

FIG. 26 is a circuit diagram of a CMOS static random-access memory (SRAM) device 400 according to some example embodiments.

The CMOS SRAM device 400 may include a pair of driving transistors 410. Each of the pair of driving transistors 410 may include a PMOS transistor 420 and an NMOS transistor 430 connected between the power terminal Vdd and the earth terminal. The CMOS SRAM device 400 may further include a pair of transfer transistors 440. A node such as a source of the transfer transistors 440 may be cross-connected to a common node of the PMOS transistor 420 and the NMOS transistor 430 which constitute the driving transistor 410. The power terminal Vdd may be connected to a node such as a source of the PMOS transistor 420, and the earth terminal may be connected to a node such as a source of the NMOS transistor 430. The word line WL may be connected to a gate of the pair of transfer transistors 440, and a bit line BL and an inverted bit line may be respectively connected to drains of the pair of transfer transistors 440.

At least one of the driving transistor 410 and the transfer transistors 440 of the CMOS SRAM device 400 may include one or more semiconductor devices according to various example embodiments described in relation to FIGS. 5 to 15, e.g., the same ones or different ones described in relation to FIGS. 5 to 15.

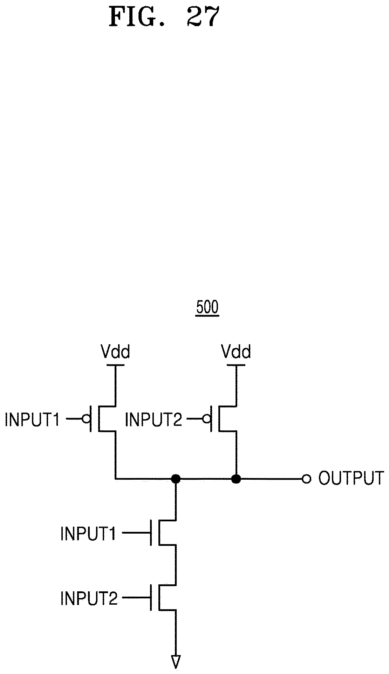

FIG. 27 is a circuit diagram of a CMOS NAND circuit 500 according to some example embodiments.

The CMOS NAND circuit 500 may include a pair of CMOS transistors which receive different input signals from each other. The CMOS NAND circuit 500 may include one or more semiconductor devices according various example embodiments described in relation to FIGS. 5 to 15.

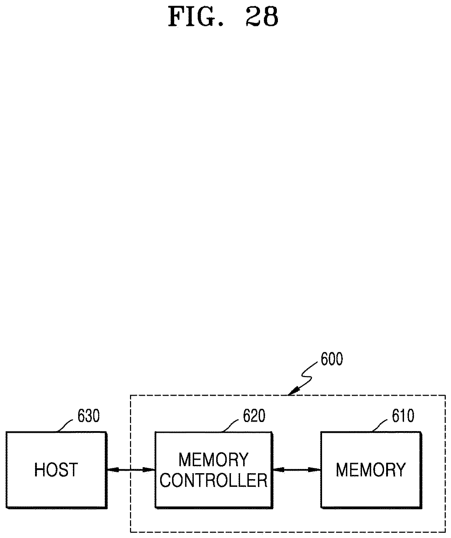

FIG. 28 is a block diagram illustrating an electronic system 600 according to some example embodiments.

The electronic system 600 may include a memory 610 and a memory controller 620. The memory controller 620 may control the memory 610 to read data from the memory 610 and/or write data on the memory 610 in response to a request from a host 630. At least one of the memory 610 and the memory controller 620 may include a semiconductor device according to some example embodiments described in relation to FIGS. 5 to 15.

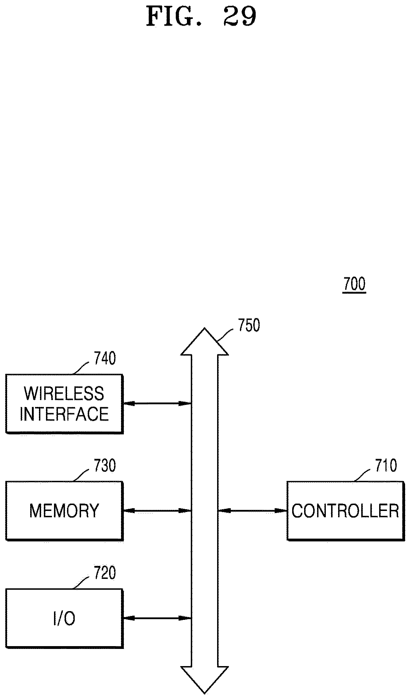

FIG. 29 is a block diagram illustrating an electronic system 700 according to some example embodiments.

The electronic system 700 may constitute or include or be included in a wireless communication device and/or a device configured to transmit and/or receive information under a wireless environment. The electronic system 700 may include a controller 710, an input/output (I/O) device 720, a memory 730, and a wireless interface 740, which are connected to each other through a bus 750.

The controller 710 may include at least one of a microprocessor, a digital signal processor, and any other similar processors. The I/O device 720 may include at least one of a keypad, a keyboard, and a display. The memory 730 may be used to store instructions performed by the controller 710. For example, the memory 730 may be used to store user data. The electronic system 700 may use the wireless interface 740 to transmit/receive data through a wireless communication network. The wireless interface 740 may include an antenna and/or a wireless transceiver. The electronic system 700 may include one or more semiconductor devices according to one or more various example embodiments described in relation to FIGS. 5 to 15.

As a semiconductor device according to some example embodiments has improved, or excellent electrical performance due to its micro-sized structure, the semiconductor device may be applied to an integrated circuit device and have characteristics of one or more of miniaturization, low power consumption, and high performance.

A semiconductor device according to some example embodiments may control or help to control formation of a metal oxide between an electrode and an oxide semiconductor layer by using a metal nitride.

By controlling the formation of a metal oxide layer on an electrode, contact resistance of the semiconductor device may be controlled and/or improved (or reduced).

Such control of the formation of the metal oxide between the electrode and the oxide semiconductor by using a metal nitride may increase the on-current density and scale down the semiconductor device. There may be an improvement in electrical performance of the semiconductor device.

Any of the elements and/or functional blocks disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit

(ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc. The processing circuitry may include electrical components such as logic gates including at least one of AND gates, OR gates, NAND gates, NOT gates, etc.

It should be understood that various example embodiments described herein should be considered in a descriptive sense only and not for purposes of limitation. Descriptions of features or aspects within each example embodiment and/or figure should typically be considered as available for other similar features and/or aspects in other embodiments. Example embodiments are not necessarily mutually exclusive with one another. While one or more embodiments have been described with reference to the figures, it will be understood by those of ordinary skill in the art that various changes in form and details may be made therein without departing from the scope as defined by the following claims.

## Claims

1. A semiconductor device comprising:
an oxide semiconductor layer;
a first electrode and a second electrode on the oxide semiconductor layer that are apart from each other;
a metal oxide layer between the oxide semiconductor layer and at least one of the first electrode and the second electrode;
a metal nitride layer between the metal oxide layer and the oxide semiconductor layer;
a gate electrode apart from the oxide semiconductor layer; and
a gate insulating layer between the oxide semiconductor layer and the gate electrode.

2. The semiconductor device of claim 1, wherein the metal nitride layer includes oxygen.

3. The semiconductor device of claim 1 or 2, wherein at least one of a thickness of the metal oxide layer and a thickness of the metal nitride layer is less than a thickness of the oxide semiconductor layer.

4. The semiconductor device of any preceding claim, wherein a thickness of the oxide semiconductor layer is 10 nm or less.

5. The semiconductor device of any preceding claim, wherein a length of the oxide semiconductor layer is less than 1 micron.

6. The semiconductor device of any preceding claim, wherein a thickness of the metal oxide layer is 5 nm or less, and optionally wherein a thickness of the metal oxide layer is 0.5 nm to 3.5 nm.

7. The semiconductor device of any preceding claim, wherein a thickness of the metal nitride layer is 10 nm or less,
and optionally wherein the metal oxide layer includes at least one of W, Co, Ni, Fe, Ti, Mo, Cr, Zr, Hf, Nb, Ta, Ag, Au, Al, Cu, Sn, V, Ru, Pt, Zn, and Mg,
and further optionally wherein the metal nitride layer includes at least one of Ga, W, Zn, V, and Ti.

8. The semiconductor device of any preceding claim, wherein a thickness of the metal oxide layer is 0.2 times to 2 times greater than a thickness of the metal nitride layer.

9. The semiconductor device of any preceding claim, wherein a thickness of the metal oxide layer is less than or equal to 25 % of a thickness of the first electrode.

10. The semiconductor device of any preceding claim, wherein the metal oxide layer includes a metal identical to a metal included in an electrode in contact with the metal oxide layer, the electrode selected from the first electrode and the second electrode.

11. The semiconductor device of any preceding claim, wherein a surface of at least one of the first electrode and the second electrode is stepped by the metal oxide layer.

12. The semiconductor device of any preceding claim, wherein a width of the metal nitride layer is greater than or equal to a width of the oxide semiconductor layer.

13. The semiconductor device of any preceding claim, wherein a difference between a width of the oxide semiconductor layer and a width of the metal nitride layer is greater than or equal to a difference between the width of the oxide semiconductor layer and a width of the metal oxide layer.

14. The semiconductor device of any preceding claim, wherein the first electrode, the metal oxide layer, the metal nitride layer, the oxide semiconductor layer, and the second electrode are arranged sequentially in a thickness direction of the first electrode.

15. The semiconductor device of claim 1, wherein the metal oxide layer includes:
a first metal oxide layer between the first electrode and the oxide semiconductor layer; and
a second metal oxide layer between the second electrode and the oxide semiconductor layer, and
the metal nitride layer is between the first metal oxide layer and the oxide semiconductor layer, and optionally wherein the metal nitride layer includes:
a first metal nitride layer between the first metal oxide layer and the oxide semiconductor layer; and
a second metal nitride layer between the second metal oxide layer and the oxide semiconductor layer.
